# EUROPEAN PATENT APPLICATION

(11) **EP 4 496 454 A1**
(43) Date of publication of application: **22.01.2025**
(21) Application number: 23887455.6
(22) Date of filing: 19.06.2023
(51) Int. Cl.: H10K 59/121, H10K 59/131, H10K 59/122, H10K 50/85, H10K 59/35, H10K 71/00

(54) **DISPLAY PANEL AND DISPLAY DEVICE**

(30) Priority: 09.11.2022 CN 202211394700
(71) Applicant: BOE Technology Group Co., Ltd., Beijing 100015 (CN); Beijing BOE Technology Development Co., Ltd., Beijing 100176 (CN)
(72) Inventor: LONG, Chunping, Beijing 100176 (CN); DAI, Qing, Beijing 100176 (CN); LI, Pan, Beijing 100176 (CN); WU, Tong, Beijing 100176 (CN)
(74) Representative: Maiwald GmbH
(86) International application number: PCT/CN2023/101010
(87) International publication number: WO 2024/098758

(57) **Abstract**

At least one embodiment of the present disclosure provides a display panel and a display device. The display panel comprises: a base substrate; an active layer, a gate, and a source and drain electrode layer that are sequentially stacked on the base substrate; and a planarization layer provided on the side of the source and drain electrode layer away from the base substrate, wherein the orthographic projection of the gate on the base substrate is within the orthographic projections of the source and drain electrode layer and the active layer on the base substrate, and in a direction perpendicular to the main surface of the base substrate, the thickness of the source and drain electrode layer is greater than the thickness of the gate. By designing the gate, the source and drain electrode layer, and the active layer to have the above-mentioned structural relationship, the flatness of the planarization layer located above the source and drain electrode layer can be reduced, namely, the surface of the planarization layer can be flatter, thereby improving the display effect of the display panel.

## Description

This patent application claims priority to the Chinese Patent Application No. 202211394700.4 filed on November 09, 2022, for all purposes, the disclosure of which is incorporated herein by reference in its entirety as part of the embodiment of the present disclosure.

### TECHNICAL FIELD

Embodiments of the present disclosure relate to a display panel and a display device.

### BACKGROUND

At present, widely used display devices include thin film transistor liquid crystal display device (TFT-LCD) and active matrix organic light emitting diode (AMOLED) display device. The active matrix organic light emitting diode (AMOLED) display device has the advantages of long service life, high display brightness, large contrast and wide color gamut.

The organic light emitting diode display device with active matrix organic light emitting diodes as light emitting elements is thinner and lighter than the conventional liquid crystal display device. The organic light emitting diode display device also has the characteristics of fast response speed, wide viewing angle and low voltage driving. Therefore, the organic light emitting diode display device can be widely used in cellular phones, portable information terminals, televisions and monitors. The organic light emitting diode display device mainly includes a cathode, a light emitting layer and an anode. In the active matrix organic light emitting diode display device, each sub-pixel has a switching transistor and a driving transistor. By adjusting the switching transistor and the driving transistor, the light emitting layer in the organic light emitting diode display device can emit light.

### SUMMARY

At least one embodiment of the present disclosure provides a display panel and a display device. In the display panel, an orthographic projection of a gate electrode on the base substrate is located within orthographic projections of a source-drain electrode layer and an active layer on the base substrate, and the thickness of the source-drain electrode layer is greater than the thickness of the gate electrode in the direction perpendicular to a main surface of the base substrate. By designing the gate electrode, the source-drain electrode layer and the active layer to have the above structural relationship, the flatness of a planarization layer above the source-drain electrode layer can be improved, that is, the surface of the planarization layer can be made flatter, so as to improve the display effect of the display panel.

At least one embodiment of the present disclosure provides a display panel, and the display panel comprises: a base substrate; an active layer, a gate electrode and a source-drain electrode layer which are sequentially stacked on the base substrate; and a planarization layer, arranged at a side of the source-drain electrode layer away from the base substrate, and an orthographic projection of the gate electrode on the base substrate is located within orthographic projections of the source-drain electrode layer and the active layer on the base substrate, and in a direction perpendicular to a main surface of the base substrate, a thickness of the source-drain electrode layer is greater than a thickness of the gate electrode.

For example, in the display panel provided by at least one embodiment of the present disclosure, a gate insulating layer is arranged between the active layer and the gate electrode, and an interlayer insulating layer is arranged between the gate electrode and the source-drain electrode layer; the source-drain electrode layer comprises a first source-drain electrode and a second source-drain electrode which are oppositely arranged; the first source-drain electrode is electrically connected with the active layer through a first via hole structure that sequentially penetrates the interlayer insulating layer and the gate insulating layer, and an orthographic projection of the gate electrode on the base substrate is located within an orthographic projection of the first source-drain electrode on the base substrate; the second source-drain electrode is electrically connected with the active layer through a second via hole structure that sequentially penetrates the interlayer insulating layer and the gate insulating layer.

For example, in the display panel provided by at least one embodiment of the present disclosure, an end portion of the first source-drain electrode away from the second source-drain electrode is electrically connected with the active layer through the first via hole structure.

For example, the display panel provided by at least one embodiment of the present disclosure, further comprises a plurality of data lines, and the plurality of data lines are arranged in the same layer as the source-drain electrode layer, and the plurality of data lines are electrically connected with corresponding second source-drain electrodes.

For example, the display panel provided by at least one embodiment of the present disclosure, further comprises a pixel defining layer arranged at a side of the planarization layer away from the base substrate, and the pixel defining layer comprises a main body part and an opening area between adjacent main body parts.

For example, the display panel provided by at least one embodiment of the present disclosure, further comprises a first electrode arranged at a side of the planarization layer away from the base substrate, the first electrode is arranged in the opening area, and the first electrode is electrically connected with the first source-drain electrode through a third via hole structure penetrating through the planarization layer.

For example, the display panel provided by at least one embodiment of the present disclosure comprises a plurality of sub-pixels, the plurality of sub-pixels comprise a first color sub-pixel, a second color sub-pixel and a third color sub-pixel which are sequentially and adjacently arranged, an orthographic projection of the first source-drain electrode corresponding to the first color sub-pixel on the base substrate has a first metal area S_{M1}, an orthographic projection of the first source-drain electrode corresponding to the second color sub-pixel on the base substrate has a second metal area S_{M2}, and an orthographic projection of the first source-drain electrode corresponding to the third color sub-pixel on the base substrate has a third metal area S_{M3}, the first metal area S_{M1} is less than or equal to the second metal area S_{M2}, and the second metal area S_{M2} is less than the third metal area SM3.

For example, in the display panel provided by at least one embodiment of the present disclosure, the first color sub-pixel, the second color sub-pixel and the third color sub-pixel are red sub-pixel, green sub-pixel and blue sub-pixel, respectively, and the first color sub-pixel has a first sub-pixel area S_{P1}, the second color sub-pixel has a second sub-pixel area S_{P2} and the third color sub-pixel has a third sub-pixel area S_{P3}, F₁= S_{M1}/S_{P1}, F₂= S_{M2}/S_{P2}, F₃= S_{M3}/S_{P3}, and F₁, F₂ and F₃ are respectively an area ratio of the first source-drain electrode corresponding to the first color sub-pixel, an area ratio of the first source-drain electrode corresponding to the second color sub-pixel and an area ratio of the first source-drain electrode corresponding to the third color sub-pixel, and F1 is greater than or equal to F₂, and F₂ is greater than F₃.

For example, in the display panel provided by at least one embodiment of the present disclosure, the area ratio F₁ of the first source-drain electrode corresponding to the first color sub-pixel, the area ratio F₂ of the first source-drain electrode corresponding to the second color sub-pixel and the area ratio F₃ of the first source-drain electrode corresponding to the third color sub-pixel are 55%, 50% and 30%, respectively.

For example, in the display panel provided by at least one embodiment of the present disclosure, the plurality of sub-pixels are arranged in an array, in a row direction, a width of the first source-drain electrode corresponding to the first color sub-pixel is less than or equal to a width of the first source-drain electrode corresponding to an adjacent second color sub-pixel, and the width of the first source-drain electrode corresponding to the second color sub-pixel is less than or equal to a width of the first source-drain electrode corresponding to an adjacent third color sub-pixel.

For example, in the display panel provided by at least one embodiment of the present disclosure, different positions of the planarization layer have different flatness, and the flatness of the planarization layer increases with a decrease of area ratios of first source-drain electrodes corresponding to the plurality of sub-pixels.

For example, in the display panel provided by at least one embodiment of the present disclosure, a first flatness F_{P1} of the planarization layer corresponding to the first color sub-pixel is less than or equal to a second flatness F_{P2} of the planarization layer corresponding to the second color sub-pixel, and the second flatness F_{P2} of the planarization layer corresponding to the second color sub-pixel is less than or equal to a third flatness F_{P3} of the planarization layer corresponding to the third color sub-pixel.

For example, in the display panel provided by at least one embodiment of the present disclosure, the first flatness F_{P1}=(H1-H1')/T, the second flatness F_{P2}=(H2-H2')/T, the third flatness F_{P3}=(H3-H3')/T, and H1 and H1' respectively are a maximum thickness and a minimum thickness of the planarization layer corresponding to the first color sub-pixel; H2 and H2' respectively are a maximum thickness and a minimum thickness of the planarization layer corresponding to the second color sub-pixel; H3 and H3' respectively are a maximum thickness and a minimum thickness of the planarization layer corresponding to the third color sub-pixel, respectively; T is an average thickness of the planarization layer.

For example, in the display panel provided by at least one embodiment of the present disclosure, |(F_{P1}-F_{P2})/(F_{P1}+F_{P2})|*100%≤10%, |(F_{P1}-F_{P3})/(F_{P1}+F_{P3})|*100%≤10%, and |(F_{P2}-F_{P3})/(F_{P2}+ F_{P3})|*100%≤10%.

For example, in the display panel provided by at least one embodiment of the present disclosure, a formula obtained by polynomial fitting an average flatness x of the planarization layer and the area ratios y of the first source-drain electrodes corresponding to the plurality of sub-pixels is y=ax2+bx+c, and a ranges from 0 to -30, b ranges from 20 to 60, and c ranges from 0 to 40.

For example, in the display panel provided by at least one embodiment of the present disclosure, the formula obtained by polynomial fitting the average flatness x of the planarization layer and the area ratios y of the first source-drain electrodes corresponding to the plurality of sub-pixels is y = -10.541x2 + 37.449x + 7.7342, and a determination coefficient R² = 1.

For example, in the display panel provided by at least one embodiment of the present disclosure, the first flatness F_{P1}, the second flatness F_{P2} and the third flatness F_{P3} are 1.5%, 2% and 2.5%, respectively.

For example, the display panel provided by at least one embodiment of the present disclosure, further comprises a power voltage signal line, and the power voltage signal line is arranged at a side of the third color sub-pixel away from the second color sub-pixel.

For example, in the display panel provided by at least one embodiment of the present disclosure, the power voltage signal line comprises a first power voltage signal line and a second power voltage signal line which are stacked, the first power voltage signal line and the source-drain electrode layer are arranged in the same layer, the second power voltage signal line and the gate electrode are arranged in the same layer, and the first power voltage signal line has an integral structure, and the second power voltage signal line comprises a fracture.

For example, in the display panel provided by at least one embodiment of the present disclosure, the power voltage signal line and a data line connected with the third color sub-pixel are respectively arranged at two sides of the third color sub-pixel, and the power voltage signal line and the data line connected with the third color sub-pixel are oppositely arranged, and in a direction from the power voltage signal line to the data line connected with the third color sub-pixel, a width of the first power voltage signal line is larger than a width of the second power voltage signal line.

For example, in the display panel provided by at least one embodiment of the present disclosure, an edge of the second power voltage signal line away from the data line connected with the third color sub-pixel is aligned with an edge of the first power voltage signal line away from the data line connected with the third color sub-pixel, and an edge of the second power voltage signal line close to the data line connected with the third color sub-pixel is located at a side of an edge of the first power voltage signal line close to the data line connected with the third color sub-pixel away from the data line connected with the third color sub-pixel.

For example, in the display panel provided by at least one embodiment of the present disclosure, the width of the first power voltage signal line is 2 to 4 times the width of the second power voltage signal line.

For example, in the display panel provided by at least one embodiment of the present disclosure, the width of the first power voltage signal line is 10 to 30 microns, and the width of the second power voltage signal line is 2 to 20 microns.

For example, in the display panel provided by at least one embodiment of the present disclosure, an orthographic projection of the main body part of the pixel defining layer on the base substrate and an orthographic projection of the first power voltage signal line on the base substrate, and an orthographic projection of the second power voltage signal line on the base substrate are at least partially overlapped with each other.

For example, in the display panel provided by at least one embodiment of the present disclosure, each of the plurality of data lines comprises a first sub-data line and a second sub-data line which are stacked, the first sub-data line and the source-drain electrode layer are arranged in the same layer, the second sub-data line and the gate electrode are arranged in the same layer, the first sub-data line has an integral structure, the second sub-data line comprises a fracture, and each of the data lines is electrically connected with the first source-drain electrode of a corresponding sub-pixel through the first sub-data line.

For example, in the display panel provided by at least one embodiment of the present disclosure, in a direction from the power voltage signal line to the data line connected with the third color sub-pixel, a width of the first sub-data line is greater than a width of the second sub-data line.

For example, in the display panel provided by at least one embodiment of the present disclosure, in the same data line of the plurality of data lines, an edge of the second sub-data line away from a sub-pixel connected with the data line is aligned with an edge of a corresponding first sub-data line away from the sub-pixel electrically connected therewith, and an edge of the second sub-data line close to the sub-pixel connected with the data line is located at a side of an edge of the corresponding first sub-data line close to the sub-pixel electrically connected therewith away from a corresponding sub-pixel.

For example, in the display panel provided by at least one embodiment of the present disclosure, in the same data line of the plurality of data lines, a width of the first sub data line is 2 to 4 times a width of the second sub data line.

For example, in the display panel provided by at least one embodiment of the present disclosure, in the same data line of the plurality of data lines, the width of the first sub-data line is 2 to 20 microns, and the width of the second sub-data line is 2 to 10 microns.

For example, in the display panel provided by at least one embodiment of the present disclosure, an orthographic projection of the main body part included in the pixel defining layer on the base substrate and orthographic projections of the first sub-data line and the second sub-data line included in the same data line of the plurality of data lines on the base substrate are at least partially overlapped with each other.

For example, in the display panel provided by at least one embodiment of the present disclosure, the thickness of the source-drain electrode layer is 3 to 7 times the thickness of the gate electrode.

For example, the display panel provided by at least one embodiment of the present disclosure, further comprises a plurality of gate lines, the plurality of gate lines and the plurality of data lines intersect to define a plurality of pixel areas, and each of the plurality of pixel areas corresponds to one of the plurality of sub-pixels.

For example, in the display panel provided by at least one embodiment of the present disclosure, the plurality of gate lines and the source-drain electrode layers are arranged in the same layer, and the plurality of gate lines and the second sub-data lines intersect with each other, and the plurality of gate lines and the first sub-data line are spaced from each other.

For example, the display panel provided by at least one embodiment of the present disclosure, further comprises a first initial signal line, a second initial signal line and a power voltage connection line, the power voltage connection line is configured to be connected with the power voltage signal line, and the first initial signal line, the second initial signal line and the power voltage connection line are all arranged in the same layer as the source-drain electrode layer and parallel to the plurality of gate lines.

For example, the display panel provided by at least one embodiment of the present disclosure, further comprises an initial signal line connection line, the initial signal line connection line is arranged at a side of the second color sub-pixel close to the third color sub-pixel, the initial signal line connection line and a data line connected with the second color sub-pixel are oppositely arranged at two sides of the second color sub-pixel, and the initial signal line connection line intersects with the first initial signal line and the second initial signal line.

For example, in the display panel provided by at least one embodiment of the present disclosure, the initial signal line connection line comprises a first sub-initial signal line connection line and a second sub-initial signal line connection line which are stacked, the first sub-initial signal line connection line and the source-drain electrode layer are arranged in the same layer, the second sub-initial signal line connection line and the gate electrode are arranged in the same layer, the first sub-initial signal line connection line has an integral structure, and the second sub-initial signal line connection line comprises a fracture.

For example, in the display panel provided by at least one embodiment of the present disclosure, in a direction from the initial signal line connection line to the data line connected with the second color sub-pixel, a width of the first sub-initial signal line connection line is greater than a width of the second sub-initial signal line connection line.

For example, in the display panel provided by at least one embodiment of the present disclosure, an edge of the second sub-initial signal line connection line away from the second color sub-pixel is aligned with an edge of the first sub-initial signal line connection line away from the second color sub-pixel, and an edge of the second sub-initial signal line connection line close to the second color sub-pixel is located at a side of an edge of first sub-initial signal line connection line close to the second color sub-pixel away from the second color sub-pixel.

For example, in the display panel provided by at least one embodiment of the present disclosure, the width of the first sub-initial signal line connection line is 2 to 3 times the width of the second sub-initial signal line connection line.

For example, in the display panel provided by at least one embodiment of the present disclosure, the width of the first sub-initial signal line connection line is 2 to 20 microns, and the width of the second sub-initial signal line connection line is 2 to 10 microns.

For example, the display panel provided by at least one embodiment of the present disclosure, further comprises a power voltage signal transmission line, the power voltage signal transmission line is arranged at a side of the first color sub-pixel close to the second color sub-pixel; the power voltage signal transmission line and a data line connected with the first color sub-pixel are arranged at two sides of the first color sub-pixel and arranged opposite to each other.

For example, in the display panel provided by at least one embodiment of the present disclosure, the power voltage signal transmission line comprises a first power voltage signal transmission line and a second power voltage signal transmission line which are stacked, the first power voltage signal transmission line and the source-drain electrode layer are arranged in the same layer, the second power voltage signal transmission line and the gate electrode are arranged in the same layer, and the first power voltage signal transmission line has an integral structure, and the second power voltage signal transmission line comprises a fracture.

For example, in the display panel provided by at least one embodiment of the present disclosure, in a direction from the power voltage signal transmission line to the data line connected with the first color sub-pixel, a width of the first power voltage signal transmission line is greater than a width of the second power voltage signal transmission line.

For example, in the display panel provided by at least one embodiment of the present disclosure, an edge of the second power voltage signal transmission line away from the data line connected with the first color sub-pixel is aligned with an edge of the first power voltage signal transmission line away from the data line connected with the first color sub-pixel, and an edge of the second power voltage signal transmission line close to the data line connected with the first color sub-pixel is located at a side of an edge of the first power voltage signal transmission line close to the edge of the data line connected with the first color sub-pixel away from the data line connected with the first color sub-pixel.

For example, in the display panel provided by at least one embodiment of the present disclosure, the width of the first power voltage signal transmission line is 2 to 3 times the width of the second power voltage signal transmission line.

For example, in the display panel provided by at least one embodiment of the present disclosure, the width of the first power voltage signal transmission line is between 2 microns and 30 microns, and the width of the second power voltage signal transmission line is between 2 microns and 10 microns.

For example, in the display panel provided by at least one embodiment of the present disclosure, the data lines extend in a first direction, and the gate lines extend in a second direction, the first direction is perpendicular to the second direction.

For example, in the display panel provided by at least one embodiment of the present disclosure, in the first direction, the width of the first power voltage signal line is W1, the width of the first sub-data line is W2, the width of the first sub-initial signal line connection line is W3, a width of the source-drain electrode layer corresponding to the third color sub-pixel is W4, and a width of the source-drain electrode layer corresponding to the second color sub-pixel is W5, a width of the source-drain electrode layer corresponding to the first color sub-pixel is W6, a width of a first gap between the first initial signal line connection line and the second color sub-pixel is W7, a spacing between the second color sub-pixel and the first power voltage signal transmission line is W8, and the width of the first power voltage signal transmission line is W9, and W1 is equal to or approximately equal to W4, |W1-W4|/|W1+W4| ≤ 0.05, (W2+W3)/min(W4, W5, W6) ≤ 0.05, (W2+ W3)/min(W4, W5, W6) ≤ 0.5, (W2+W9)/min(W4, W5, W6) ≤ 0.5, W7/min(W4, W5, W6) ≤ 0.5, W8/min(W4, W5, W6) ≤ 0.05, |W8-W7|/min(W4, W5, W6) ≤ 0.25, |W8-W7|/|W8+W7| ≤ 0.4.

For example, in the display panel provided by at least one embodiment of the present disclosure, a line width spacing ratio K_{ws} of each of the gate lines satisfies K_{ws}=Wₘ/Sₘ, where Wₘ is a line width of the each of the gate lines, Sₘ is a spacing between adjacent ones of the gate lines, and a value of K_{ws} is in the range of 0 to 1; a fluctuation slope Kₑₘ of a convex part of the planarization layer corresponding to each of the gate lines Kₑₘ = Hₑₘ/Lₑₘ, where Hₑₘ is a convex height of the convex part and Lₑₘ is a convex width of the convex part, and a value of Kₑₘ is in the range of 1 to 2; the fluctuation slope Kₑₘ of the planarization layer and the line width spacing ratio K_{ws} of each of the gate lines satisfy Kₑₘ= aK_{ws}³ +bK_{ws}²+ cK_{ws} +d, where a ranges from -20 to 0, b ranges from 0 to 20, c ranges from -10 to 10, and d ranges from -10 to 10.

For example, in the display panel provided by at least one embodiment of the present disclosure, a formula obtained by polynomial fitting the fluctuation slope Kₑₘ of the planarization layer and the line width spacing ratio K_{ws} of each of the gate lines is Kₑₘ= -5.5036K_{ws}³ +4.8397K_{ws}²+ 0.7095K_{ws} +0.8259, and a determination coefficient R² = 0.9699.

For example, the display panel provided by at least one embodiment of the present disclosure, further comprises a light emitting element arranged at a side of the first electrode away from the base substrate, the light emitting element comprises a light emitting layer and an organic functional layer stacked with the light emitting layer, and the light emitting layer is formed by a printing process, and the organic functional layer is formed by a vapor deposition process.

For example, in the display panel provided by at least one embodiment of the present disclosure, the light emitting element comprises a red light emitting element, a green light emitting element and a blue light emitting element; a ratio of a thickness of a red light emitting layer included in the red light emitting element to a peak wavelength of red light ranges from 0.15 to 0.4; a ratio of a thickness of a green light emitting layer included in the green light emitting element to a peak wavelength of green light ranges from 0.15 to 0.3; a ratio of a thickness of a blue light emitting layer included in the blue light emitting element to a peak wavelength of blue light ranges from 0.1 to 0.2.

For example, in the display panel provided by at least one embodiment of the present disclosure, a ratio of a sum of thicknesses of a plurality of red light emitting layers and corresponding organic functional layers to the peak wavelength of red light ranges from 0.2 to 0.4; a ratio of a sum of thicknesses of a plurality of green light emitting layers and corresponding organic functional layers to the peak wavelength of green light ranges from 0.2 to 0.3; a ratio of a sum of thicknesses of a plurality of blue light emitting layers and corresponding organic functional layers to a peak wavelength of blue light ranges from 0.15 to 0.25.

At least one embodiment of the present disclosure further comprises a display device, and the display device comprises any one of the display panels mentioned above.

### BRIEF DESCRIPTION OF DRAWINGS

In order to more clearly explain the technical solution of the embodiments of the present disclosure, the accompanying drawings of the embodiments will be briefly introduced below. Obviously, the accompanying drawings in the following description only relate to some embodiments of the present disclosure, and are not limited to the present disclosure.
Fig. 1A is a schematic cross-sectional view of a display panel provided by at least one embodiment of the present disclosure;
Fig. 1B is a schematic cross-sectional view of another display panel provided by at least one embodiment of the present disclosure;
Fig. 2A is a schematic plan view of a display panel provided by at least one embodiment of the present disclosure;
Fig. 2B is a schematic plan view of a single layer of an active layer in Fig. 2A;
Fig. 2C is a schematic diagram of a superimposed plane structure of an active layer and a gate electrode in Fig. 2A;
Fig. 3 is a schematic plan view of a sub-pixel and a corresponding source-drain electrode layer provided by at least one embodiment of the present disclosure;
Fig. 4 is a schematic cross-sectional view of a sub-pixel and a corresponding source-drain electrode layer provided by at least one embodiment of the present disclosure;
Fig. 5 is a schematic plan view of another sub-pixel and a corresponding source-drain electrode layer provided by at least one embodiment of the present disclosure;
Fig. 6 is a schematic cross-sectional view of another sub-pixel and a corresponding source-drain electrode layer provided by at least one embodiment of the present disclosure;
Fig. 7 is a schematic plan view of another display panel provided by at least one embodiment of the present disclosure;
Fig. 8A is a schematic plan view of a power voltage signal line provided by at least one embodiment of the present disclosure;
Fig. 8B is a schematic plan view of a single layer of an active layer in Fig. 8A;
Fig. 8C is a schematic diagram of a plane structure in which the active layer, the gate electrode and a part of the data line in Fig. 8A are superimposed;
Fig. 9 is a schematic cross-sectional view of still another display panel provided by at least one embodiment of the present disclosure;
Fig. 10 is a schematic plan view of still another display panel provided by at least one embodiment of the present disclosure;
Fig. 11 is a schematic cross-sectional view of a display panel provided by at least one embodiment of the present disclosure;
Fig. 12 is a schematic plan view of still another display panel provided by at least one embodiment of the present disclosure;
Fig. 13 is a schematic diagram of a circuit structure of a display panel provided by at least one embodiment of the present disclosure;
Fig. 14 is a schematic diagram of a circuit structure of another display panel provided by at least one embodiment of the present disclosure;
Fig. 15 is a schematic cross-sectional view of still another display panel provided by at least one embodiment of the present disclosure; and
Fig. 16 is a block diagram of a display device provided by at least one embodiment of the present disclosure.

### DETAILED DESCRIPTION

In order to make the purpose, technical solution and advantages of the embodiment of the present disclosure clearer, the technical solution of the embodiment of the present disclosure will be described clearly and completely with the accompanying drawings. Obviously, the described embodiment is a part of the embodiment of the present disclosure, not the whole embodiment. Based on the described embodiments of the present disclosure, all other embodiments obtained by ordinary people in the field without creative labor belong to the scope of protection of the present disclosure.

Unless otherwise defined, technical terms or scientific terms used in this disclosure shall have their ordinary meanings as understood by people with ordinary skills in the field to which this disclosure belongs. The terms "first", "second" and the like used in this disclosure do not indicate any order, quantity or importance, but are only used to distinguish different components. Similar words such as "including" or "comprising" mean that the elements or objects appearing before the word cover the elements or objects listed after the word and their equivalents, without excluding other elements or objects. Similar words such as "connected" or "connected" are not limited to physical or mechanical connection, but can include electrical connection, whether direct or indirect. "Up", "Down", "Left" and "Right" are only used to indicate the relative positional relationship. When the absolute position of the described object changes, the relative positional relationship may also change accordingly.

At present, widely used display devices include thin film transistor liquid crystal display (TFT-LCD), active matrix organic light emitting diode display (AMOLED) and so on. The AMOLED display device has the advantages of long service life, high display brightness, large contrast and wide color gamut. Usually, the AMOLED display device includes a planarization film arranged on a pixel driving circuit, and the flatness of the planarization film has a great influence on the performance of the AMOLED display device. By adjusting the ratio of a capacitor area to a pixel area of each sub-pixel, setting the numerical value of the ratio of the capacitor area to the pixel area and a corresponding size relationship, the flatness of the planarization film on the pixel driving circuit can be improved, and the flatness of the planarization film can also be improved by adjusting the line width of each signal line and the spacing between adjacent signal lines.

At least one embodiment of the present disclosure provides a display panel including a base substrate, an active layer, a gate electrode and a source-drain electrode layer which are sequentially stacked on the base substrate, and a planarization layer arranged at a side of the source-drain electrode layer away from the base substrate, an orthographic projection of the gate electrode on the base substrate is located within orthographic projections of the source-drain electrode layer and the active layer on the base substrate, and in a direction perpendicular to a main surface of the base substrate, a thickness of the source-drain electrode layer is greater than a thickness of the gate electrode. By designing the gate electrode, the source-drain electrode layer and the active layer to have the above structural relationship, the flatness of the planarization layer above the source-drain electrode layer can be improved, that is, the surface of the planarization layer can be made flatter, so as to improve the display effect of the display panel.

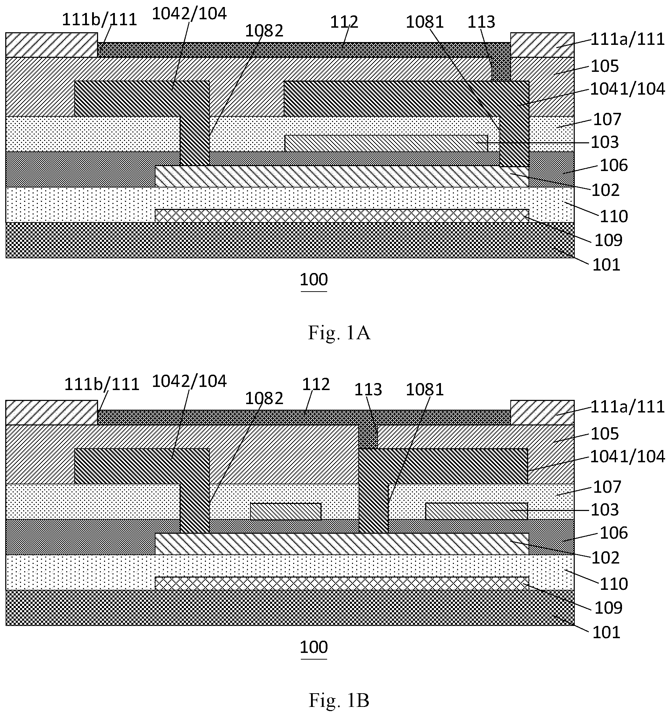

For example, Fig. 1A is a schematic cross-sectional view of a display panel provided by at least one embodiment of the present disclosure. As illustrated by Fig. 1A, the display panel 100 includes a base substrate 101, an active layer 102, a gate electrode 103, and a source-drain electrode layer 104 which are sequentially stacked on the base substrate 101, and a planarization layer 105 arranged at a side of the source-drain electrode layer 104 away from the base substrate 101. An orthographic projection of the gate electrode 103 on the base substrate 101 is located within orthographic projections of the source-drain electrode layer 104 and the active layer 102 on the base substrate 101, that is, the orthographic projection of the source-drain electrode layer 104 on the base substrate 101 covers the orthographic projection of the gate electrode 103 on the base substrate 101, and the orthographic projection of the active layer 102 on the base substrate 101 also covers the orthographic projection of the gate electrode 103 on the base substrate 101. And, in a direction perpendicular to a main surface of the base substrate 101, the thickness of the source-drain electrode layer 104 is greater than the thickness of the gate electrode 103. Setting the source-drain electrode layer 104 to cover the gate electrode 103 can reduce the problem of step difference caused by the thickness difference of different metal layers, so that the planarization layer is mostly kept flat at least at the positions corresponding to the pixel opening area, and setting the thickness of the source-drain electrode layer 104 to be greater than the thickness of the gate electrode 103 can further reduce the influence of the step difference caused by the gate electrode 103 with a certain thickness on the flatness of the planarization layer 105.

For example, through the design in Fig. 1A, the flatness of the planarization layer 105 located above the source-drain electrode layer 104 can be improved, that is, the orthographic projection of the gate electrode 103 with the smallest orthographic projection area on the base substrate 101 is located within the orthographic projection of the source-drain electrode layer 104 on the base substrate 101, and the source-drain electrode layer 104 is directly above the gate electrode 103 and covers the whole gate electrode 103, which can make the flatness of the planarization layer 105 corresponding to the pixel area better.

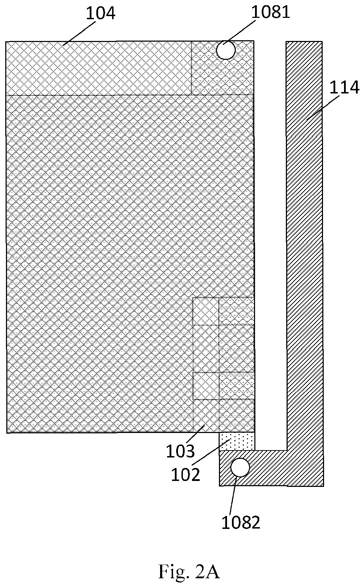

For example, Fig. 2A is a schematic plan view of a display panel provided by at least one embodiment of the present disclosure. With reference to Figs. 1A and 2A, the area of the source-drain electrode layer 104 is larger than the area of the gate electrode 103, and the edge of the source-drain electrode layer 104 exceeds the edge of the gate electrode 103, that is, the source-drain electrode layer 104 covers the gate electrode 103 completely, so as to minimize the problem of large flatness of the planarization layer 105 caused by the existence of the gate electrode 103.

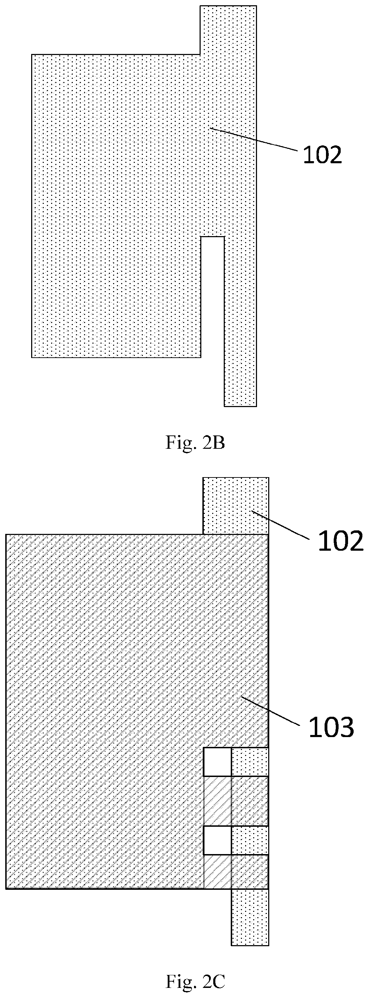

For example, Fig. 2B is a schematic plan view of a single layer of an active layer in Fig. 2A, and Fig. 2C is a schematic diagram of a superimposed plane structure of an active layer and a gate electrode in Fig. 2A. As illustrated by Fig. 2B, the active layer 102 has a whole layer structure, which includes a left rectangle shape and a right elongated shape, and the left rectangle shape and the right elongated shape are connected into an integrated structure. As illustrated by Fig. 2C, in the plan structure in which the active layer 102 and the gate electrode 103 are superimposed, two branches of the gate electrode 103 have overlapping parts with the elongated shape of the active layer 102, and a part of the gate electrode 103 parallel to the two branches also has an overlapping part with the elongated shape of the active layer 102.

For example, as illustrated by Fig. 1A, a gate insulating layer 106 is provided between the active layer 102 and the gate electrode 103, and an interlayer insulating layer 107 is provided between the gate electrode 103 and the source-drain electrode layer 104. The source-drain electrode layer 104 includes a first source-drain electrode 1041 and a second source-drain electrode 1042 which are oppositely arranged. The first source-drain electrode 1041 is electrically connected with the active layer 102 through a first via hole structure 1081 that sequentially penetrates the interlayer insulating layer 107 and the gate insulating layer 106, and an orthographic projection of the gate electrode 103 on the base substrate 101 is located within an orthographic projection of the first source-drain electrode 1041 on the base substrate 101; the second source-drain electrode 1042 is electrically connected with the active layer 102 through a second via hole structure 1082 that sequentially penetrates the interlayer insulating layer 107 and the gate insulating layer 106.

For example, the orthographic projection of the gate electrode with the smallest orthographic projection area on the base substrate is located within the orthographic projection of the source-drain electrode layer on the base substrate, that is, the source-drain electrode layer is located directly above the gate electrode and cover the whole gate electrode, which can make the flatness of the planarization layer corresponding to the pixel area smaller.

For example, as illustrated by Fig. 1A, an end portion of the first source-drain electrode 1041 away from the second source-drain electrode 1042 is electrically connected with the active layer 102 through the first via hole structure 1081. In this way, the first source-drain electrode 1041 can completely cover the gate electrode 103, thereby minimizing the problem of poor flatness of the planarization layer 105 due to the existence of the gate electrode 103. In addition, the area of the source-drain electrode layer included in the storage capacitor can be increased to improve the voltage holding capacity of the driving transistor.

It should be noted that, in Fig. 1A, the second via hole structure 1082 is arranged at a position corresponding to an edge of the second source-drain electrode 1042, and the first via hole structure 1081 is also arranged at a position corresponding to an edge of the first source-drain electrode 1041, and both the second via hole structure 1082 and the first via hole structure 1081 are arranged at the right edges, but the embodiment of the present disclosure is not limited thereto, and the first via hole structure 1081 may be arranged at a position corresponding to a middle part of the first source-drain electrode 1041, and the second via hole structure 1082 may be arranged at a position corresponding to a middle part of the second source-drain electrode 1042. Alternatively, the first via hole structure 1081 may be arranged at the left edge of the first source-drain electrode 1041, and the second via hole structure 1082 may be arranged at a position corresponding to the middle part of the second source-drain electrode 1042. It is also possible that the first via hole structure 1081 is arranged at the left edge of the first source-drain electrode 1041 and the second via hole structure 1082 is arranged at the right edge of the second source-drain electrode 1042, and the embodiments of the present disclosure are not limited thereto.

For example, as illustrated by Fig. 1A, at a side of the active layer 102 close to the base substrate 101, a light shielding layer 109 is further provided, a first insulating layer 110 is provided on the light shielding layer 109, and a pixel defining layer 111 is provided at a side of the planarization layer 105 away from the base substrate 101. The pixel defining layer 111 includes a main body part 111a and an opening area 111b between adjacent main body parts 111a, a sub-pixel of one color is formed in the opening area 111b, respectively, that is, the main body part 111a separate adjacent sub-pixels.

For example, as illustrated by Fig. 1A, in order to further improve the flatness of the planarization layer, the position where the first source-drain electrode 1041 contacts the active layer 102 is adjusted, that is, the position of the first via hole structure 1081 is optimized, the position where the first electrode 112 is electrically connected with the first source-drain electrode 1041 is adjusted, that is, the position of the third via hole structure 113 is optimized, thereby increasing the area of the storage capacitor and further improving the voltage holding capacity of the corresponding driving transistor. In addition, according to the design in Fig. 1A, the electrode area of the first source-drain electrode layer included in the storage capacitor can be increased, so that the flatness of the planarization layer above the source-drain electrode layer can be improved. The pixel circuit structure of the display panel shown in Fig. 1A is a 4T1C structure that can be internally compensated, and the driving transistor can be composed of two thin film transistors connected in series.

For example, in at least one embodiment of the present disclosure, the display panel 100 further includes a plurality of data lines 114, which are arranged in the same layer as the source-drain electrode layer 104, and are electrically connected with corresponding second source-drain electrodes 1042. For example, as illustrated by Fig. 2A, only one data line 114 is shown, and the data line 114 is electrically connected with the second source-drain electrode 1042 through the second via hole structure 1082. Other data lines have the same connection relationship with the corresponding second source-drain electrodes 1042, which will not be described here.

For example, as illustrated by Fig. 1A, the display panel 100 further includes a first electrode 112 arranged at a side of the planarization layer 105 away from the base substrate 101, the first electrode 112 is arranged in the opening area 111b, and is electrically connected with the first source-drain electrode 1041 through a third via hole structure 113 arranged in the planarization layer 105, thereby realizing the driving effect of the driving transistor on the sub-pixels, and a part of the first electrode 112 away from the edge of the second source-drain electrode 1042 is electrically connected with the first source-drain electrode 1041.

For example, setting the first source-drain electrode 1041 with the above structure is beneficial to improving the flatness of the planarization layer 105, that is, reducing the roughness of the planarization layer 105, so that the flatness of the first electrode 112 and the flatness of the light emitting layer and organic functional layers provided on the first electrode 112 can be improved, and the uniformity of light emitted by the light emitting element can be improved.

It should be noted that the first source-drain electrode is used as an electrode of the storage capacitor, and the first source-drain electrode has an integral structure and a large area, so that the first source-drain electrode can cover a large area of pixel area, and the thickness of the first source-drain electrode exceeds 500 nm, so that the flatness of the planarization layer can be improved. Moreover, the larger the metal area of the first source-drain electrode, the better the flatness of the planarization layer is improved. The planar shape of the first source-drain electrode can be rectangular, square or irregular shape, as long as the planar shape of the first source-drain electrode can match the planar shape of the pixel area, and the embodiment of the present disclosure is not limited thereto. For example, in one example, the planar area of the first source-drain electrode is larger than the planar area of the gate electrode, and the orthographic projection of the gate electrode on the base substrate is located within the orthographic projection of the first source-drain electrode layer on the base substrate, and the edge of the first source-drain electrode layer exceeds the edge of the gate electrode.

It should also be noted that only a part of the layer structure of the display panel is shown in Fig. 1A, but not all the layer structure of the display panel. The structure not shown can refer to the conventional structure, which is not limited by the embodiment of the present disclosure.

For example, forming the display panel 100 in Fig. 1A includes the following process steps: providing a base substrate 101, sequentially depositing a first buffer layer film and a second buffer layer film on the base substrate 101, and patterning the first buffer layer film and the second buffer layer film to form a buffer layer; depositing a monocrystalline silicon film on the buffer layer, and performing dehydrogenation, hydrogen fluoride cleaning and excimer laser annealing processes on the monocrystalline silicon film to form a polysilicon layer, and then performing an etching process under the shielding of a mask plate to complete a first mask process; doping the polysilicon layer with boron fluoride, then cleaning the polysilicon layer with hydrogen fluoride, performing a second mask process on the polysilicon layer with a mask plate, and then doping the polysilicon layer with sulfur hexafluoride; performing a third mask process on the polysilicon layer, then performing nitrogen doping, and then depositing a gate insulating film; depositing a gate electrode material on the gate insulating film, then performing a fourth mask process and etching the gate electrode material to form a gate electrode, then depositing an interlayer insulating film material on the gate electrode, and performing a fifth mask process and etching the interlayer insulating film material to form an interlayer insulating layer; depositing a source-drain electrode layer film, performing a sixth mask process and etching the source-drain electrode layer film to form a source-drain electrode layer, depositing a passivation layer film on the source-drain electrode layer, and performing a seventh mask process and etching passivation layer film to form a passivation layer; depositing a planarization layer film on the passivation layer, and performing an eighth mask process on the planarization layer to form the planarization layer; depositing a first electrode material on the planarization layer, and then performing a ninth patterning process on the first electrode material to form a first electrode; then, depositing a pixel defining layer film on the first electrode, and performing a tenth mask process and etching the pixel defining layer film to form the pixel defining layer. That is, the whole preparation process includes ten mask processes.

For example, in one example, with reference to Fig. 1A, the thickness of the light shielding layer 109 is 2510 angstroms, and the material of the light shielding layer includes molybdenum metal. The thickness of the first buffer layer is 500 angstroms, and the thickness of the second buffer layer is 1100 angstroms. The materials of the first buffer layer and the second buffer layer are both silicon oxide. The thickness of the active layer 102 is 500 angstroms, and the material of the active layer 102 includes nitrogen-containing low-temperature polysilicon. The thickness of the gate insulating layer 106 is 1100 angstroms, and the material of the gate insulating layer 106 includes silicon oxide. The thickness of the gate electrode 103 is 2510 angstroms, and the material of the gate electrode 103 includes molybdenum metal. The thickness of the interlayer insulating layer 107 is 5600 angstroms, and the material of the interlayer insulating layer 107 includes silicon oxide or silicon nitride. The source-drain electrode layer 104 has a thickness of 7000 angstroms, and the source-drain electrode layer 104 includes a three-layer laminated structure, that is, an aluminum metal layer is sandwiched between two titanium metal layers, the thickness of the two titanium metal layers is 500 angstroms respectively, and the thickness of the middle aluminum metal layer is 6000 angstroms. The thickness of the insulating layer on the source-drain electrode layer 104 is 4460 angstroms, and the material of the insulating layer includes silicon oxynitride. The planarization layer 105 on the insulating layer has a thickness of 49,000 angstroms, and the material of the planarization layer is a photocurable resin material. A first electrode 112 is disposed on the planarization layer 105, and the thickness of the first electrode 112 is 1660 angstroms. A pixel defining layer 111 is disposed on the first electrode 112, and the thickness of the pixel defining layer 111 is 10900 angstroms, and the material of the pixel defining layer 111 is an organic insulating material. On the pixel defining layer 111, a black matrix with a thickness of 10,600 angstroms is provided, and the material of the black matrix is a black resin material. The display panel also includes a red light emitting layer, a green light emitting layer and a blue light emitting layer, the thicknesses of the red light emitting layer, the green light emitting layer and the blue light emitting layer are all 25,800 angstroms, and the materials of the red light emitting layer, the green light emitting layer and the blue light emitting layer are all organic light emitting materials. The display panel also includes an optical adhesive with a thickness of 80,000 angstroms.

For example, from the above example, it can be seen that the thickness of the source-drain metal layer is relatively large, and the source-drain metal layer can reduce the unevenness and un-flatness of the thin film of the wiring and pixel structure located at a side of the source-drain metal layer close to the base substrate, so that the flatness of the planarization layer at the side of the source-drain electrode layer away from the base substrate can be improved.

For example, Fig. 1B is a schematic cross-sectional view of another display panel provided by at least one embodiment of the present disclosure. As illustrated by Fig. 1B, the display panel 100 includes a base substrate 101, an active layer 102, a gate electrode 103 and a source-drain electrode layer 104 which are sequentially stacked on the base substrate 101, and a planarization layer 105 arranged at a side of the source-drain electrode layer 104 away from the base substrate 101. The orthographic projection of the gate electrode 103 on the base substrate 101 is located within orthographic projections of the source-drain electrode layer 104 and the active layer 102 on the base substrate 101, that is, the orthographic projection of the source-drain electrode layer 104 on the base substrate 101 covers the orthographic projection of the gate electrode 103 on the base substrate 101, and the orthographic projection of the active layer 102 on the base substrate 101 also covers the orthographic projection of the gate electrode 103 on the base substrate 101. And in the direction perpendicular to the main surface of the base substrate 101, the thickness of the source-drain electrode layer 104 is greater than the thickness of the gate electrode 103. Setting the source-drain electrode layer 104 to cover the gate electrode 103 can reduce the problem of step difference caused by the thickness difference of different metal layers, so that the planarization layer is mostly kept flat at least at the position corresponding to the pixel opening area, and setting the thickness of the source-drain electrode layer 104 to be greater than the thickness of the gate electrode 103 can further reduce the influence of the step difference caused by the gate electrode 103 with a certain thickness on the flatness of the planarization layer 105.

For example, in Fig. 1B, an end portion of the first source-drain electrode 1041 close to the second source-drain electrode 1042 is electrically connected with the active layer 102 through a first via hole structure 1081, the first via hole structure 1081 penetrates the gate insulating layer 106 and the interlayer insulating layer 107. The first electrode 112 is electrically connected with the first source-drain electrode 1041 through a third via hole structure 113 arranged in the planarization layer 105, so that the driving transistor can drive the sub-pixel, and a middle part of the first electrode 112 is electrically connected with the first source-drain electrode 1041.

It should be noted that in Fig. 1B, two branches of the gate electrode 103 are shown, and the two branches are connected with each other. In the cross-sectional view shown in Fig. 1B, although the branch of the gate electrode 103 between the first source-drain electrode 1041 and the second source-drain electrode 1042 is not covered by the first source-drain electrode 1041, in the plan view shown in Fig. 2A, an orthographic projection of the branch of the gate electrode 103 on the base substrate 101 is located within the orthographic projection of the first source-drain electrode 1041 on the base substrate 101, and the orthographic projection of the branch of the gate electrode 103 on the base substrate 101 is also within the orthographic projection of the active layer 102 on the base substrate 101.

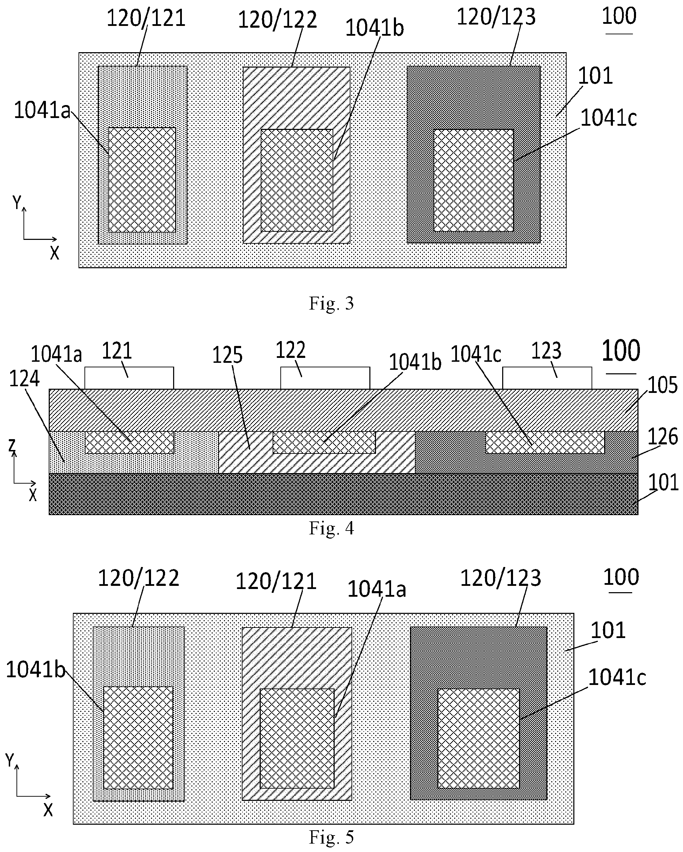

For example, Fig. 3 is a schematic plan view of a sub-pixel and a corresponding source-drain electrode layer provided by at least one embodiment of the present disclosure, and Fig. 4 is a schematic cross-sectional view of a sub-pixel and a corresponding source-drain electrode layer provided by at least one embodiment of the present disclosure. As illustrated by Fig. 3, the display panel 100 includes a plurality of sub-pixels 120 including a first color sub-pixel 121, a second color sub-pixel 122 and a third color sub-pixel 123 which are sequentially adjacent to each other. With reference to Fig. 2A, each sub-pixel 120 corresponds to one data line 114. The orthographic projection of the first source-drain electrode 1041a corresponding to the first color sub-pixel 121 on the base substrate 101 has a first metal area S_{M1}, the orthographic projection of the first source-drain electrode 1041b corresponding to the second color sub-pixel 122 on the base substrate 101 has a second metal area S_{M2}, and the orthographic projection of the first source-drain electrode 1041c corresponding to the third color sub-pixel 123 on the base substrate 101 has a third metal area S_{M3}. The first metal area S_{M1} is smaller than or equal to the second metal area S_{M2}, and the second metal area S_{M2} is smaller than the third metal area S_{M3}, that is, the areas of the first source-drain electrodes 1041 corresponding to the first color sub-pixel 121, the second color sub-pixel 122 and the third color sub-pixel 123 which emit different colors of light are different. In Fig. 3, the first metal area S_{M1} is smaller than the second metal area S_{M2}, and the second metal area S_{M2} is smaller than the third metal area S_{M3}.

It should be noted that, in the AMOLED display device, because the red light emitting material, the green light emitting material and the blue light emitting material have different light emitting efficiency and service life, the red sub-pixel driving circuit driving the red sub-pixel to emit light, the green sub-pixel driving circuit driving the green sub-pixel to emit light, and the blue sub-pixel driving circuit driving the blue sub-pixel to emit light in the pixel array have different storage capacitor areas, and/or a red sub-pixel driving transistor for driving the red sub-pixel to emit light, a green sub-pixel driving transistor for driving the green sub-pixel to emit light, and a blue sub-pixel driving transistor for driving the blue sub-pixel to emit light are all different in size and area, so that different driving currents can be provided for the red light emitting material, the green light emitting material and the blue light emitting material respectively, and different storage capacitances can be provided when the red sub-pixel driving transistor, the green sub-pixel driving transistor and the blue sub-pixel driving transistor keep different driving currents. For example, at present, the service life of blue AMOLED is shorter than the service life of red AMOLED and the service life of green AMOLED, so it can be considered that the required color characteristics, such as white balance, can be obtained by increasing the light emitting area of blue sub-pixel after reducing the driving current of the blue sub-pixel driving transistor. For example, the first color sub-pixel 121, the second color sub-pixel 122 and the third color sub-pixel 123 in the above can be red sub-pixel, green sub-pixel and blue sub-pixel, respectively.

For example, Fig. 3 shows the first color sub-pixel 121, the second color sub-pixel 122 and the third color sub-pixel 123 and their internal storage capacitors. Each storage capacitor includes two opposite layers of metal thin film electrodes and one or more layers of insulating media, and the area of the storage capacitor is defined as the area of one of the metal thin film electrodes. For example, the two opposite layers of metal thin film electrodes included in the storage capacitor can be the first source-drain electrode and the gate electrode, for example, the area of the metal thin film electrode (first source-drain electrode) away from the base substrate is selected as the area of the storage capacitor, or the area of the metal thin film electrode (first source-drain electrode) close to the planarization layer is selected as the area of the storage capacitor.

For example, as illustrated by Fig. 4, the display panel 100 includes a first color sub-pixel driving circuit 124, a second color sub-pixel driving circuit 125 and a third color sub-pixel driving circuit 126 which are sequentially arranged on the base substrate 101. The first color sub-pixel driving circuit 124 includes a first source-drain electrode 1041a corresponding to the first color sub-pixel, the second color sub-pixel driving circuit 125 includes the first source-drain electrode 1041b corresponding to the second color sub-pixel 122, and the third color sub-pixel driving circuit 126 includes the first source-drain electrode 1041c corresponding to the third color sub-pixel 123.

The embodiment of the present disclosure improves the flatness of the planarization layer by adjusting a ratio of the area of each sub-pixel to the area of the first source-drain electrode corresponding to each sub-pixel.

For example, a ratio of the area Sₘ of the storage capacitor to the area Sₚ of the pixel area is defined as an area ratio: Fₘ=Sₘ/Sₚ. The area of the storage capacitor can be the area of the source-drain electrode layer. For example, in one example, the area of the storage capacitor corresponding to a first color sub-pixel (for example, a red sub-pixel) is smaller than or equal to the area of the storage capacitor corresponding to a second color sub-pixel (for example, a green sub-pixel), and the area of the storage capacitor corresponding to a second color sub-pixel (for example, the green sub-pixel) is smaller than the area of the storage capacitor corresponding to a third color sub-pixel (for example, a blue sub-pixel). The area ratio of the first color sub-pixel (for example, red sub-pixel) is greater than or equal to the area ratio of the second color sub-pixel (for example, the green sub-pixel), and the area ratio of the second color sub-pixel (for example, the green sub-pixel) is greater than the area ratio of the third color sub-pixel (for example, the blue sub-pixel).

It should be noted that the area Sₚ of the pixel area includes the area of the storage capacitor, but does not include the area of the signal lines.

It should also be noted that the metal film electrode of the storage capacitor away from the base substrate can be the first source-drain electrode, and the first source-drain electrode is covered by a planarization layer, the planarization layer may or may not be in direct contact with the first source-drain electrode. The flatness of the planarization layer is defined as Fₚ=(hₘₐₓ-hₘᵢₙ)/T_{PLN}, where hₘₐₓ is the height of the highest point of the planarization layer, hₘᵢₙ is the height of the lowest point of the planarization layer, and T_{PLN} is the thickness of the planarization layer. For example, taking the case where the first color sub-pixel is a red sub-pixel, the second color sub-pixel is a green sub-pixel and the third color sub-pixel is a blue sub-pixel as an example, corresponding to the sub-pixels with different colors, the relationship between the flatness Fₚ of the planarization layer satisfies: F_{P3} ≥ F_{P2} ≥ F_{P1}, where F_{P1} is the flatness of the planarization layer corresponding to the first color sub-pixel and F_{P2} is the flatness of the planarization layer corresponding to the second color sub-pixel, F_{P3} is the flatness of the planarization layer corresponding to the second color sub-pixel.

For example, in one example, the area ratio Fₘ₁ of the first color sub-pixel is 62.3333, and the flatness F_{P1} of the planarization layer corresponding to the first color sub-pixel is 1.2546; the area ratio Fₘ₂ of the second color sub-pixel is 59.2626, and the flatness F_{P2} of the planarization layer corresponding to the second color sub-pixel is 1.4906; the area ratio Fₘ₃ of the third color sub-pixel is 39.6856, and the flatness F_{P3} of the planarization layer corresponding to the third color sub-pixel is 2.0768.

For example, after fitting, it is found that the flatness of the planarization layer corresponding to the sub-pixels with different colors increases with the decrease of the area ratio of the sub-pixels. After fitting in different ways, it is found that polynomial precision > linear precision > exponential precision > logarithmic precision > power fitting precision, and the polynomial formed after polynomial fitting is y=-24.795x²+55.055x+32.289, and the determination coefficient R² = 1.

For example, in one example, the plurality of sub-pixels 120 are arranged in an array. In a row direction of sub-pixel arrangement, that is, in the direction along the X axis in Fig. 3, the width of the first source-drain electrode 1041a corresponding to the first color sub-pixel 121 is less than or equal to the width of the first source-drain electrode 1041b corresponding to an adjacent second color sub-pixel 122, and the width of the first source-drain electrode 1041b corresponding to the second color sub-pixel 122 is less than or equal to the width of the first source-drain electrode 1041c corresponding to an adjacent third color sub-pixel 123.

For example, in one example, the plurality of sub-pixels 120 are arranged in an array. In a row direction of sub-pixel arrangement, that is, in the direction along the X axis in Fig. 4, the overall length of the first color sub-pixel driving circuit 124 is smaller than the overall length of the second color sub-pixel driving circuit 125 and smaller than the overall length of the third color sub-pixel driving circuit 126.

It should be noted that the direction parallel to the Y axis is a column direction of sub-pixel arrangement, and the direction parallel to the Z axis is the direction perpendicular to the main surface of the base substrate 101.

For example, in one example, the first color sub-pixel 121, the second color sub-pixel 122 and the third color sub-pixel 123 are red sub-pixel, green sub-pixel and blue sub-pixels, respectively. The first color sub-pixel 121 has a first sub-pixel area S_{P1}, the second color sub-pixel 122 has a second sub-pixel area S_{P2}, and the third color sub-pixel 123 has a third sub-pixel area S_{P3}, F1= S_{M1}/S_{P1}, F2= S_{M2}/S_{P2}, F3= S_{M3}/S_{P3}, F1, F2 and F3 are the area ratios of the first source-drain electrode 1041a corresponding to the first color sub-pixel 121, the first source-drain electrode 1041b corresponding to the second color sub-pixel 122 and the first source-drain electrode 1041c corresponding to the third color sub-pixel 123, respectively, and F1 is greater than or equal to F2, and F2 is greater than F3, that is, the area ratios of the first source-drain electrode 1041 corresponding to the sub-pixels 120 of different colors are different.

For example, in the display panel provided by at least one embodiment of the present disclosure, the area ratio F1 of the first source-drain electrode 1041a corresponding to the first color sub-pixel 121, the area ratio F2 of the first source-drain electrode 1041b corresponding to the second color sub-pixel 122 and the area ratio F3 of the first source-drain electrode 1041c corresponding to the third color sub-pixel 123 are 55%, 50% and 30% respectively.

For example, in one example, different portions of the planarization layer 105 at different positions have different flatness, and the flatness of the planarization layer 105 increases with the decrease of the area ratios of the first source-drain electrodes 1041 corresponding to the sub-pixels 120, that is, the flatness of the planarization layer 105 corresponding to the red sub-pixel, the green sub-pixel and the blue sub-pixel is different.

For example, in one example, the first flatness F_{P1} of the planarization layer 105 corresponding to the first color sub-pixel 121 is less than or equal to the second flatness F_{P2} of the planarization layer 105 corresponding to the second color sub-pixel 122, and the second flatness F_{P2} of the planarization layer 105 corresponding to the second color sub-pixel 122 is less than or equal to the third flatness F_{P3} of the planarization layer 105 corresponding to the third color sub-pixel 123.

For example, in one example, the first flatness F_{P1}=(H1-H1')/T, the second flatness F_{P2}=(H2-H2')/T, and the third flatness F_{P3}=(H3-H3')/T, where H1 and H1' are the maximum thickness and the minimum thickness of the planarization layer 105 corresponding to the first color sub-pixel 121, respectively, H2 and H2' are the maximum thickness and minimum thickness of the planarization layer 105 corresponding to the second color sub-pixel 122, respectively; H3 and H3' are the maximum thickness and minimum thickness of the planarization layer 105 corresponding to the third color sub-pixel 123, respectively; and T is the average thickness of the planarization layer 105, that is, the thicknesses of different portions of the planarization layer 105 at different positions are measured, and then the average thickness is calculated to obtain the above-mentioned T.

For example, in one example, the following formula can be obtained: |(F_{P1}-F_{P2})/(F_{P1}+F_{P2})|*100% ≤ 10%, |(F_{P1}-F_{P3})/(F_{P1}+F_{P3})|*100% ≤ 10%, 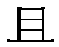 |(F_{P2}-F_{P3})/(F_{P2}+ F_{P3})|*100% ≤ 10%.

For example, in one example, the formula obtained by polynomial fitting the average flatness x of the planarization layer 105 with the area ratio y of the first source-drain electrode 1041 corresponding to each sub-pixel 120 is y=ax²+bx+c, and a ranges from 0 to 30, b ranges from 20 to 60, and c ranges from 0 to 40.

For example, the formula obtained by polynomial fitting the average flatness x of the planarization layer 105 and the area ratio y of the first source-drain electrode 1041 corresponding to each sub-pixel 120 is y=-10.541x²+37.449x+7.7342, and the determination coefficient R² = 1.

For example, in one example, the sizes of the first flatness F_{P1}, the second flatness F_{P2} and the third flatness F_{P3} are 1.5%, 2% and 2.5%, respectively.

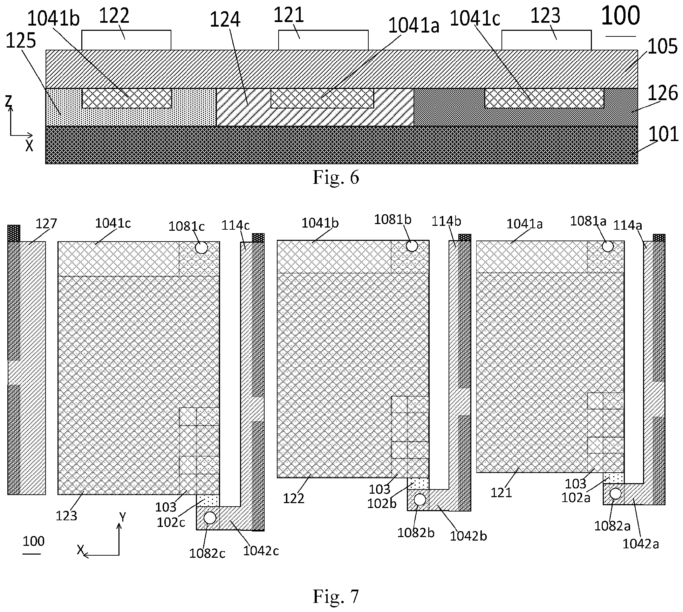

For example, Fig. 5 is a schematic plan view of another sub-pixel and a corresponding source-drain electrode layer provided by at least one embodiment of the present disclosure, and Fig. 6 is a schematic cross-sectional view of another sub-pixel and a corresponding source-drain electrode layer provided by at least one embodiment of the present disclosure. As illustrated by Fig. 5, the display panel 100 includes a plurality of sub-pixels 120, which include a second color sub-pixel 122, a first color sub-pixel 121 and a third color sub-pixel 123 which are arranged adjacent to each other in sequence. With reference to Fig. 2A, each sub-pixel 120 corresponds to one data line 114. The orthographic projection of the first source-drain electrode 1041b corresponding to the second color sub-pixel 122 on the base substrate 101 has a second metal area S_{M2}, the orthographic projection of the first source-drain electrode 1041a corresponding to the first color sub-pixel 121 on the base substrate 101 has a first metal area S_{M1}, and the orthographic projection of the first source-drain electrode 1041c corresponding to the third color sub-pixel 123 on the base substrate 101 has a third metal area S_{M3}. The second metal area S_{M2} is smaller than or equal to the first metal area S_{M1}, and the first metal area S_{M1} is smaller than the third metal area S_{M3}, that is, the areas of the first source-drain electrodes 1041 corresponding to the first color sub-pixel 121, the second color sub-pixel 122 and the third color sub-pixel 123 which emit different colors of light are different. In Fig. 3, the second metal area S_{M2} is smaller than the first metal area S_{M1}, and the first metal area S_{M1} is smaller than the third metal area SM3.

It should be noted that, in the AMOLED display device, because the red light emitting material, the green light emitting material and the blue light emitting material have different light emitting efficiency and service life, the red sub-pixel driving circuit driving the red sub-pixel to emit light, the green sub-pixel driving circuit driving the green sub-pixel to emit light, and the blue sub-pixel driving circuit driving the blue sub-pixel to emit light in the pixel array have different storage capacitor areas, and/or a red sub-pixel driving transistor for driving the red sub-pixel to emit light, a green sub-pixel driving transistor for driving the green sub-pixel to emit light, and a blue sub-pixel driving transistor for driving the blue sub-pixel to emit light are all different in size and area, so that different driving currents can be provided for the red light emitting material, the green light emitting material and the blue light emitting material respectively, and different storage capacitances can be provided when the red sub-pixel driving transistor, the green sub-pixel driving transistor and the blue sub-pixel driving transistor keep different driving currents. For example, at present, the service life of blue AMOLED is shorter than the service life of red AMOLED and the service life of green AMOLED, so it can be considered that the required color characteristics, such as white balance, can be obtained by increasing the light emitting area of blue sub-pixel after reducing the driving current of blue sub-pixel driving transistor. For example, the first color sub-pixel 121, the second color sub-pixel 122 and the third color sub-pixel 123 in the above can be red sub-pixel, green sub-pixel and blue sub-pixel, respectively.

For example, Fig. 5 shows a first color sub-pixel 121, a second color sub-pixel 122 and a third color sub-pixel 123 and their internal storage capacitors. Each storage capacitor includes two opposite layers of metal thin film electrodes and one or more layers of insulating media, and the area of the storage capacitor is defined as the area of one of the metal thin film electrodes. For example, the two opposite layers of metal thin film electrodes included in the storage capacitor can be the first source-drain electrode and the gate electrode, for example, the area of the metal thin film electrode (first source-drain electrode) away from the base substrate is selected as the area of the storage capacitor, or the area of the metal thin film electrode (first source-drain electrode) close to the planarization layer is selected as the area of the storage capacitor.

For example, as illustrated by Fig. 6, the display panel 100 includes a second color sub-pixel driving circuit 125, a first color sub-pixel driving circuit 124 and a third color sub-pixel driving circuit 126, which are sequentially arranged on the base substrate 101. The second color sub-pixel driving circuit 125 includes a first source-drain electrode 1041b corresponding to the second color sub-pixel, the first color sub-pixel driving circuit 124 includes a first source-drain electrode 1041a corresponding to the first color sub-pixel 121, and the third color sub-pixel driving circuit 126 includes a first source-drain electrode 1041c corresponding to the third color sub-pixel 123.

The embodiment of the present disclosure improves the flatness of the planarization layer by adjusting a ratio of the area of each sub-pixel to the area of the first source-drain electrode corresponding to each sub-pixel.

For example, a ratio of the area Sₘ of the storage capacitor to the area Sₚ of the pixel area is defined as an area ratio: Fₘ=Sₘ/Sₚ. The area of the storage capacitor can be the area of the source-drain electrode layer. For example, in one example, the area of the storage capacitor corresponding to a second color sub-pixel (for example, a green sub-pixel) is smaller than or equal to the area of a first color sub-pixel (for example, a red sub-pixel), and the area of the storage capacitor corresponding to a first color sub-pixel (for example, a red sub-pixel) is smaller than the area of the storage capacitor corresponding to a third color sub-pixel (for example, a blue sub-pixel). The area ratio of the second color sub-pixel (for example, the green sub-pixel) is greater than or equal to the area ratio of the first color sub-pixel (for example, the red sub-pixel), and the area ratio of the first color sub-pixel (for example, the red sub-pixel) is greater than the area ratio of the third color sub-pixel (for example, blue sub-pixel).

It should be noted that the area Sₚ of the pixel area includes the area of the storage capacitor, but does not include the area of the signal lines.

It should also be noted that the metal film electrode of the storage capacitor away from the base substrate can be the first source-drain electrode, and the first source-drain electrode is covered with a planarization layer, which may or may not be in direct contact with the first source-drain electrode. The flatness of the planarization layer is defined as Fₚ=(hₘₐₓ-hₘᵢₙ)/T_{PLN}, where hₘₐₓ is the height of the highest point of the planarization layer, hₘᵢₙ is the height of the lowest point of the planarization layer, and T_{PLN} is the thickness of the planarization layer. For example, taking the case where the first color sub-pixel is a red sub-pixel, the second color sub-pixel is a green sub-pixel and the third color sub-pixel is a blue sub-pixel as an example, corresponding to the sub-pixels with different colors, the relationship between the flatness Fₚ of the planarization layer satisfies: Fₚ₃≥ Fₚ₁≥ Fₚ₂, where F_{P1} is the flatness of the planarization layer corresponding to the first color sub-pixel and F_{P2} is the flatness of the planarization layer corresponding to the second color sub-pixel, F_{P3} is the flatness of the planarization layer corresponding to the second color sub-pixel.

For example, in one example, the area ratio Fₘ₂ of the second color sub-pixel is 62.3333, and the flatness F_{P2} of the planarization layer corresponding to the second color sub-pixel is 1.2546; the area ratio Fₘ₁ of the first color sub-pixel is 59.2626, and the flatness F_{P1} of the planarization layer corresponding to the first color sub-pixel is 1.4906; the area ratio Fₘ₃ of the third color sub-pixel is 39.6856, and the flatness F_{P3} of the planarization layer corresponding to the third color sub-pixel is 2.0768.

For example, after fitting, it is found that the flatness of the planarization layer corresponding to the sub-pixels with different colors increases with the decrease of the area ratio of the sub-pixels. After fitting in different ways, it is found that polynomial precision > linear precision > exponential precision > logarithmic precision > power fitting precision, and the polynomial formed after polynomial fitting is y=-24.795x²+55.055x+32.289, and the determination coefficient R² = 1.

For example, in one example, the plurality of sub-pixels 120 are arranged in an array. In a row direction of sub-pixel arrangement, that is, in the direction along the X axis in Fig. 5, the width of the first source-drain electrode 1041b corresponding to the second color sub-pixel 122 is less than or equal to the width of the first source-drain electrode 1041a corresponding to an adjacent first color sub-pixel 121, and the width of the first source-drain electrode 1041a corresponding to the first color sub-pixel 121 is less than or equal to the width of the first source-drain electrode 1041c corresponding to an adjacent third color sub-pixel 123.

For example, in one example, the plurality of sub-pixels 120 are arranged in an array. In a row direction of sub-pixel arrangement, that is, in the direction along the X axis in Fig. 6, the overall length of the second color sub-pixel driving circuit 125 is smaller than the overall length of the first color sub-pixel driving circuit 124, and the overall length of the first color sub-pixel driving circuit 124 is smaller than the overall length of the third color sub-pixel driving circuit 126.

It should be noted that the direction parallel to the Y axis is a column direction of sub-pixel arrangement, and the direction parallel to the Z axis is the direction perpendicular to the main surface of the base substrate 101.

For example, in one example, the first color sub-pixel 121, the second color sub-pixel 122 and the third color sub-pixel 123 are red sub-pixel, green sub-pixel and blue sub-pixels, respectively. The first color sub-pixel 121 has a first sub-pixel area S_{P1}, the second color sub-pixel 122 has a second sub-pixel area S_{P2}, and the third color sub-pixel 123 has a third sub-pixel area S_{P3}, F1= S_{M1}/S_{P1}, F2= S_{M2}/S_{P2}, F3= S_{M3}/S_{P3}, F1, F2 and F3 are the area ratios of the first source-drain electrode 1041a corresponding to the first color sub-pixel 121, the first source-drain electrode 1041b corresponding to the second color sub-pixel 122 and the first source-drain electrode 1041c corresponding to the third color sub-pixel 123, respectively, and F2 is greater than or equal to F1, and F1 is greater than F3, that is, the area ratios of the first source-drain electrode 1041 corresponding to the sub-pixels 120 of different colors are different.

For example, in the display panel provided by at least one embodiment of the present disclosure, the area ratio F2 of the first source-drain electrode 1041b corresponding to the second color sub-pixel 122, the area ratio F1 of the first source-drain electrode 1041a corresponding to the first color sub-pixel 121, and the area ratio F3 of the first source-drain electrode 1041c corresponding to the third color sub-pixel 123 are 55%, 50% and 30%, respectively.

For example, in one example, different portions of the planarization layer 105 at different positions have different flatness, and the flatness of the planarization layer 105 increases with the decrease of the area ratios of the first source-drain electrodes 1041 corresponding to the sub-pixels 120, that is, the flatness of the planarization layer 105 corresponding to the red sub-pixel, the green sub-pixel and the blue sub-pixel is different.

For example, in one example, the second flatness F_{P2} of the planarization layer 105 corresponding to the second color sub-pixel 122 is less than or equal to the first flatness F_{P1} of the planarization layer 105 corresponding to the first color sub-pixel 121, and the first flatness F_{P1} of the planarization layer 105 corresponding to the first color sub-pixel 121 is less than or equal to the third flatness F_{P3} of the planarization layer 105 corresponding to the third color sub-pixel 123.

For example, in one example, the first flatness F_{P1}=(H1-H1')/T, the second flatness F_{P2}=(H2-H2')/T, and the third flatness F_{P3}=(H3-H3')/T, where H1 and H1' are the maximum thickness and the minimum thickness of the planarization layer 105 corresponding to the first color sub-pixel 121, respectively, H2 and H2' are the maximum thickness and minimum thickness of the planarization layer 105 corresponding to the second color sub-pixel 122, respectively; H3 and H3' are the maximum thickness and minimum thickness of the planarization layer 105 corresponding to the third color sub-pixel 123, respectively; and T is the average thickness of the planarization layer 105, that is, the thicknesses of different positions of the planarization layer 105 are measured, and then the average thickness is calculated to obtain the above-mentioned T.

For example, in one example, the following formula can be obtained: |(F_{P2}-F_{P1})/(F_{P1}+ F_{P2})|*100% ≤ 10%, |(F_{P2}-F_{P3})/(F_{P2}+F_{P3})|*100% ≤ 10%, 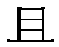 |(F_{P1}-F_{P3})/(F_{P1}+ F_{P3})|*100% ≤ 10%.

For example, in one example, the formula obtained by polynomial fitting the average flatness x of the planarization layer 105 with the area ratio y of the first source-drain electrode 1041 corresponding to each sub-pixel 120 is y=ax²+bx+c, and a ranges from 0 to 30, b ranges from 20 to 60, and c ranges from 0 to 40.

For example, the formula obtained by polynomial fitting the average flatness x of the planarization layer 105 and the area ratio y of the first source-drain electrode 1041 corresponding to each sub-pixel 120 is y=-10.541x²+37.449x+7.7342, and the determination coefficient R² = 1.

For example, in one example, the sizes of the second flatness F_{P2}, the first flatness F_{P1} and the third flatness F_{P3} are 1.5%, 2% and 2.5%, respectively.

For example, Fig. 7 is a schematic plan view of another display panel provided by at least one embodiment of the present disclosure. As illustrated by Fig. 7, the display panel 100 further includes a power voltage signal line 127, the power voltage signal line 127 is arranged at a side of the third color sub-pixel 123 away from the second color sub-pixel 122. A power voltage signal line 127 is not provided around the first color sub-pixel 121 and the second color sub-pixel 122.

It should be noted that the area of the pixel area corresponding to the third color sub-pixel 123 is the largest, and the width of the power voltage signal line 127 in the direction where the sub-pixels are arranged in the X-axis direction is relatively wide, so the power voltage signal line 127 is suitable to be arranged at the position corresponding to the third color sub-pixel 123 with a large area.

For example, as illustrated by Fig. 7, the plurality of sub-pixels 120 include a first color sub-pixel 121, a second color sub-pixel 122 and a third color sub-pixel 123 which are sequentially adjacent to each other along the first direction X, and the first color sub-pixel 121, the second color sub-pixel 122 and the third color sub-pixel 123 correspond to the first source-drain electrode 1041a, the first source-drain electrode 1041b and the first source-drain electrode 1041c, respectively. The first source-drain electrode 1041a is electrically connected with the active layer 102 through a first via hole structure 1081a that sequentially penetrates the interlayer insulating layer 107 and the gate insulating layer 106. The first source-drain electrode 1041b is electrically connected with the active layer 102 through a first via hole structure 1081b that sequentially penetrates the interlayer insulating layer 107 and the gate insulating layer 106. The first source-drain electrode 1041c is electrically connected with the active layer 102 through a first via hole structure 1081c that sequentially penetrates the interlayer insulating layer 107 and the gate insulating layer 106. The first color sub-pixel 121, the second color sub-pixel 122 and the third color sub-pixel 123 correspond to the second source-drain electrode 1042a, the second source-drain electrode 1042b and the second source-drain electrode 1042c, respectively. The second source-drain electrode 1042a is electrically connected with the data line 114a through a second via hole structure 1082a that sequentially penetrates the interlayer insulating layer 107 and the gate insulating layer 106. The second source-drain electrode 1041b is electrically connected with the data line 114b through a second via hole structure 1082b that sequentially penetrates the interlayer insulating layer 107 and the gate insulating layer 106. The second source-drain electrode 1041c is electrically connected with the data line 114c through a second via hole structure 1082c that sequentially penetrates the interlayer insulating layer 107 and the gate insulating layer 106. The gate electrodes 103 corresponding to the first color sub-pixel 121, the second color sub-pixel 122 and the third color sub-pixel 123 all include two branch structures, and the two branch structures are connected with each other. The planar areas of the first source-drain electrode 1041a, the first source-drain electrode 1041b and the first source-drain electrode 1041c corresponding to the first color sub-pixel 121, the second color sub-pixel 122 and the third color sub-pixel 123 sequentially increase.

For example, in Fig. 7, the power voltage signal line 127, the data line 114a corresponding to the first color sub-pixel 121, the data line 14b corresponding to the second color sub-pixel 122 and the data line 114c corresponding to the third color sub-pixel 123 all include a stacked double-layer structure.

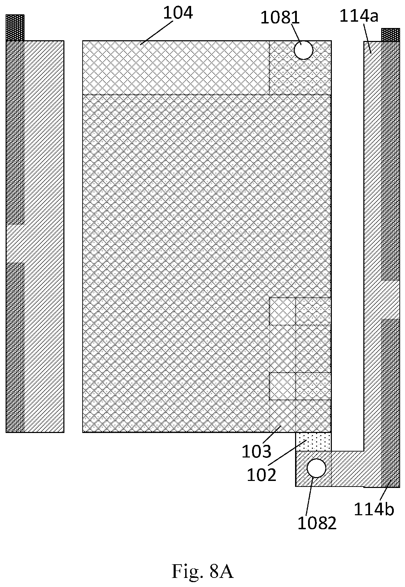

For example, Fig. 8A is a schematic plan view of a power voltage signal line provided by at least one embodiment of the present disclosure, as illustrated by Fig. 8A, the power voltage signal line 127 and the data line 114 connected with the third color sub-pixel 123 are respectively arranged on opposite sides of the third color sub-pixel 123, and the power voltage signal line 127 and the data line 114 connected with the third color sub-pixel 123 are arranged oppositely. In a direction from power voltage signal line 127 to the data line 114 connected with the third color sub-pixel 123, the width of the first power voltage signal line 127a is greater than the width of the second power voltage signal line 127b.

It should be noted that in Fig. 8A, except at the position of the upper edge, the second power voltage signal line 127b is not overlapped with the first power voltage signal line 127a, at the other position, an orthographic projection of the second power voltage signal line 127b on the base substrate 101 is located within an orthographic projection of the first power voltage signal line 127a on the base substrate 101.

For example, as illustrated by Fig. 8A, an edge of the second power voltage signal line 127b away from the data line 114 connected with the third color sub-pixel 123 is aligned with an edge of the first power voltage signal line 127a away from the data line 114 connected with the third color sub-pixel 123, and an edge of the second power voltage signal line 127b close to the data line 114 connected with the third color sub-pixel 123 is located at a side of an edge of the first power voltage signal line 127a close to the data line connected with the third color sub-pixel 123 away from the data line 114 connected with the third color sub-pixel 123.

For example, in one example, the width of the first power voltage signal line 127a is 2 to 4 times the width of the second power voltage signal line 127b. For example, the width of the first power voltage signal line 127a is 2 times, 3 times or 4 times the width of the second power voltage signal line 127b, which is not limited by the embodiment of the present disclosure.

For example, in one example, the width of the first power voltage signal line 127a ranges from 10 microns to 30 microns, and the width of the second power voltage signal line 127b ranges from 2 microns to 20 microns. For example, in one example, the width of the first power voltage signal line 127a is 10 microns, and the width of the second power voltage signal line 127b is 5 microns; in another example, the width of the first power voltage signal line 127a is 16 microns, and the width of the second power voltage signal line 127b is 8 microns; in another example, the width of the first power voltage signal line 127a is 22 microns, and the width of the second power voltage signal line 127b is 11 microns; in another example, the width of the first power voltage signal line 127a is 30 microns, and the width of the second power voltage signal line 127b is 15 microns, that is, the width of the first power voltage signal line 127a is twice the width of the second power voltage signal line 127b.

For example, in one example, the width of the first power voltage signal line 127a is 12 microns, and the width of the second power voltage signal line 127b is 4 microns; in another example, the width of the first power voltage signal line 127a is 15 microns, and the width of the second power voltage signal line 127b is 5 microns; in another example, the width of the first power voltage signal line 127a is 30 microns, and the width of the second power voltage signal line 127b is 10 microns, that is, the width of the first power voltage signal line 127a is three times that of the second power voltage signal line 127b.

For example, in one example, the width of the first power voltage signal line 127a is 12 microns, and the width of the second power voltage signal line 127b is 3 microns; in another example, the width of the first power voltage signal line 127a is 16 microns, and the width of the second power voltage signal line 127b is 4 microns; in yet another example, the width of the first power voltage signal line 127a is 20 microns, and the width of the second power voltage signal line 127b is 5 microns; in another example, the width of the first power voltage signal line 127a is 24 microns, and the width of the second power voltage signal line 127b is 6 microns; in another example, the width of the first power voltage signal line 127a is 28 microns, and the width of the second power voltage signal line 127b is 7 microns, that is, the width of the first power voltage signal line 127a is four times that of the second power voltage signal line 127b.

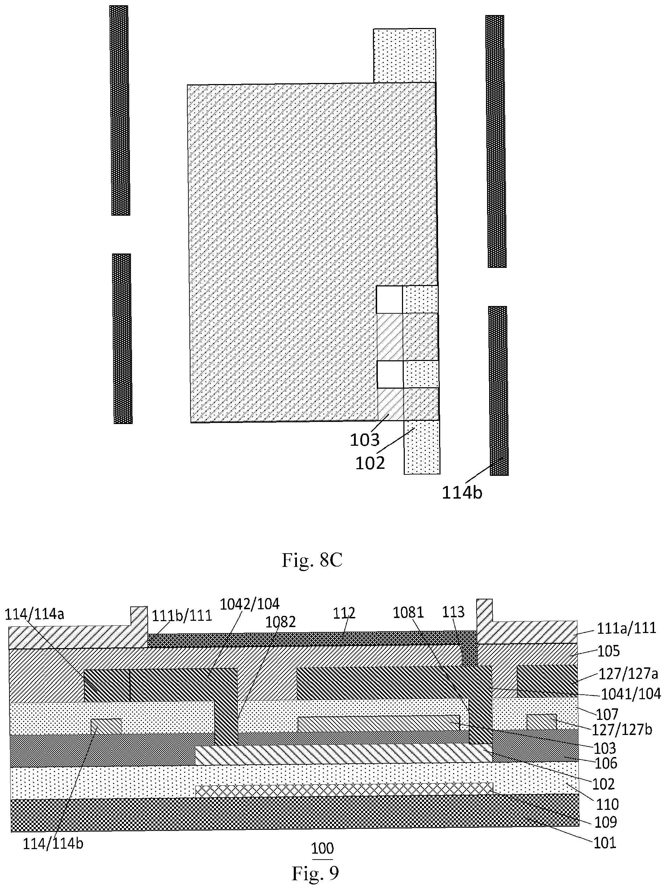

For example, Fig. 9 is a schematic cross-sectional view of another display panel provided by at least one embodiment of the present disclosure. As illustrated by Fig. 9, the power voltage signal line 127 includes a first power voltage signal line 127a and a second power voltage signal line 127b which are stacked, the first power voltage signal line 127a and the source-drain electrode layer 1041 are arranged in the same layer, the second power voltage signal line 127b and the gate electrode 103 are arranged in the same layer, and the first power voltage signal line 127a has an integral structure, and the second power voltage signal line 127b includes a fracture, so that the current can flow on the whole of the first power voltage signal line 127a, and the area where the current flows becomes larger.

For example, as illustrated by Fig. 9, the first power voltage signal line 127a and the second power voltage signal lines 127b which are stacked can reduce the resistance of the power voltage signal line 127, and the second power voltage signal line 127b includes a fracture, so as to enable electrical conduction of the first power voltage signal line 127a on the upper layer.

For example, as illustrated by Fig. 9, because the first power voltage signal line 127a and the source-drain electrode layer 1041 are arranged in the same layer, and the second power voltage signal line 127b and the gate electrode 103 are arranged in the same layer, even if the first power voltage signal line 127a and the second power voltage signal line 127b are arranged in a double-layer structure, the degree of the formed step difference will not be increased, but a new step difference will be formed at a different position, so that the flatness of the planarization layer will not be affected.

For example, the first power voltage signal line 127a has a whole layer structure, and the larger width of the first power voltage signal line 127a can make the current flow in a larger area, so that the working efficiency of the power voltage signal line 127 can be higher.

For example, as illustrated by Fig. 9, an orthographic projection of the main body 111a of the pixel defining layer 111 on the base substrate 101, an orthographic projection of the first power voltage signal line 127a on the base substrate 101, and an orthographic projection of the second power voltage signal line 127b on the base substrate 101 at least partially overlap. The stacked arrangement of the main body part 111a of the pixel defining layer 111, the first power voltage signal line 127a and the second power voltage signal line 127b can cushion the main body part 111a, so that more space can be realized to form the related structure of the sub-pixel.

For example, in combination with Figs. 7 and 8A, each of the data lines 114 includes a first sub-data line 114a and a second sub-data line 114b which are stacked, the first sub-data line 114a and the source-drain electrode layer 104 are arranged in the same layer, and the second sub-data line 114b is arranged in the same layer as the gate electrode 103, the first sub-data line 114a has an integral structure, the second sub-data line 114b includes a fracture, and each of the data lines 114 is electrically connected with the first source-drain electrode 1041 corresponding to the sub pixel 120 through the first sub-data line 114a.

For example, as illustrated by Fig. 7, the first sub-data line 114a and the second sub-data line 114b which are stacked can reduce the resistance of the data line 114, and the second sub-data line 114b includes a fracture to enable the first sub-data line 114a on the upper layer to achieve electrical conduction.

For example, as illustrated by Fig. 7, because the first sub-data line 114a and the source-drain electrode layer 1041 are arranged in the same layer, and the second sub-data line 14b and the gate electrode 103 are arranged in the same layer, even if the first sub-data line 114a and the second sub-data line 114b are arranged in a double-layer structure, the degree of the formed step difference will not be increased, but a new step difference will be formed at different positions, so that the flatness of the planarization layer will not be affected.

For example, the first sub-data line 114a has a whole layer structure, and the larger width of the first sub-data line 114a can make the current flow in a larger area, thus making the working efficiency of the data line 114 higher.

For example, as illustrated by Fig. 7, in the direction from the power voltage signal line 127 to the data line 114 connected with the third color sub pixel 123, the width of the first sub-data line 114a is greater than the width of the second sub-data line 114b.

It should be noted that the stacked structure of the first sub-data line 114a and the second sub-data line 14b may be a data line corresponding to the third color sub-pixel 123, or a data line corresponding to the first color sub-pixel 121 or a data line corresponding to the second color sub-pixel 122, which is not limited by the embodiment of the present disclosure.

For example, as illustrated by Fig. 7, in the same data line 114, an edge of the second sub-data line 114b away from the sub-pixel 120 connected with the data line 114 where the second sub-data line 114a is located is aligned with an edge of a corresponding first sub-data line 114a away from the sub-pixel 120 electrically connected therewith, and an edge of the second sub-data line 114b close to the sub-pixel 120 connected with the data line 114 where the second sub-data line 114a is located is located at a side of an edge of the corresponding first sub-data line 114a close to the sub-pixel 120 electrically connected therewith away from the corresponding sub-pixel 120.

For example, in the display panel provided by at least one embodiment of the present disclosure, in the same data line 114, the width of the first sub-data line 114a is 2 to 4 times the width of the second sub-data line 114b, for example, the width of the first sub-data line 114a is 2, 3 or 4 times that of the second sub-data line 114b.

For example, in one example, in the same data line 114, the width of the first sub-data line 114a ranges from 2 microns to 20 microns, and the width of the second sub-data line 114b ranges from 2 microns to 10 microns. This range can reduce the resistance of the data line 114 and increase the flow area of the current on the data line 114.

For example, in one example, the width of the first sub-data line 114a is 4 microns, and the width of the second sub-data line 114b is 2 microns; in another example, the width of the first sub-data line 114a is 10 microns, and the width of the second sub-data line 114b is 5 microns; in yet another example, the width of the first sub-data line 114a is 16 microns, and the width of the second sub-data line 114b is 8 microns; in yet another example, the width of the first sub-data line 114a is 20 microns and the width of the second sub-data line 114b is 10 microns, so that the width of the first sub-data line 114a is twice that of the second sub-data line 114b.

For example, in one example, the width of the first sub-data line 114a is 6 microns, and the width of the second sub-data line 114b is 2 microns; in another example, the width of the first sub-data line 114a is 12 microns, and the width of the second sub-data line 114b is 4 microns; in yet another example, the width of the first sub-data line 114a is 15 microns, and the width of the second sub-data line 114b is 5 microns; in yet another example, the width of the first sub-data line 114a is 18 microns and the width of the second sub-data line 114b is 6 microns, so that the width of the first sub-data line 114a is three times that of the second sub-data line 114b.

For example, in one example, the width of the first sub-data line 114a is 8 microns, and the width of the second sub-data line 114b is 2 microns; in another example, the width of the first sub-data line 114a is 12 microns, and the width of the second sub-data line 114b is 3 microns; in yet another example, the width of the first sub-data line 114a is 16 microns, and the width of the second sub-data line 114b is 4 microns; in yet another example, the width of the first sub-data line 114a is 20 microns, and the width of the second sub-data line 114b is 5 microns, so that the width of the first sub-data line 114a is four times that of the second sub-data line 114b.

For example, the planar shape of the first sub-data line 114a is an inverted "L" shape, and the first sub-data line 114a is electrically connected with the second source-drain electrode 1042 through a horizontal line extending from a vertical line.

For example, as illustrated by Fig. 7, by setting the power voltage signal line 127 and the data line 114 to have a double-layer structure, the pixel areas of the first color sub-pixel, the second color sub-pixel and the third color sub-pixel and the area of the storage capacitor corresponding to the first source-drain electrode can be optimized. On the premise that the power voltage signal line 127 and the data line 114 are both set to have a double-layer structure, the thicknesses of the planarization layer are measured, and the relevant data as obtained are shown in Table 1 below.

**Table 1:**

| Unit | Micron | Micron | Micron | Micron | flatness | First source-drain electrode | |
|---|---|---|---|---|---|---|---|
| First source-drain | Width of the capacitor | Height of the capacitor | hₘₐₓ-hₘᵢₙ | Thickness of the planarization | (hₘₐₓ-hₘᵢₙ) /T_{PLN} | Area ratio | percentage |
| electrode | region | region | | layer | | | |
| Red sub-pixel | 17.6 | 55 | 87.5 | 4.7 | 1.861702 | 0.409165 | 40.91653 |
| Green sub-pixel | 20.9 | 55 | 105 | 4.7 | 2.234043 | 0.387844 | 38.78438 |
| Blue sub-pixel | 22 | 55 | 112.5 | 4.7 | 2.425532 | 0.365497 | 36.54971 |

For example, in Fig. 7, the relationship between the flatness of the planarization layer and the area ratio of the first source-drain electrode included in the storage capacitor in the pixel area satisfies:
Polynomial fitting: y = -10.541x²+37.449x +7.7342, R² = 1;
Linear fitting: y = -7.4693x + 54.987, R² = 0.9618;
Exponential fitting: y = 58.818e^{-0.192x}, R² = 0.9553;
Logarithmic fitting: y = -15.711n(x) + 50.852, R² = 0.9487;
Power fitting: y = 52.865^{x}-0.405, R² = 0.9412.

For example, R² is a numerical value ranging from 0 to 1, when the R² of the trend line is equal to or close to 1, its reliability is the highest, and on the contrary, the reliability is lower. R² is also called the determining coefficient. The calculation method of R² is provided as follows: R²= sum of regression squares (ssreg)/sum of total squares (sstotal), where sum of regression squares = sum of total squares-sum of residual squares (ssresid), polynomial precision > linear precision > exponential precision > logarithmic precision > power fitting precision.

For example, the coefficient symbols of polynomial fitting are the same, and the roughness of the planarization layer increases with the decrease of the area ratio of capacitor/pixel. The data show that the planarization layer of the capacitor areas of red sub-pixel, green sub-pixel and blue sub-pixel has different flatness Fp. And, the flatness of the planarization layer corresponding to different sub-pixels satisfies that the first flatness F_{P1} of the planarization layer corresponding to the red sub-pixel is less than or equal to the second flatness F_{P2} of the planarization layer corresponding to the green sub-pixel, and the second flatness F_{P2} of the planarization layer corresponding to the green sub-pixel is less than or equal to the third flatness F_{P3} of the planarization layer corresponding to the blue sub-pixel. The electrode widths of the storage capacitors in pixel areas corresponding to the red sub-pixel, the green sub-pixel and the blue sub-pixel satisfy that the electrode width of storage capacitor corresponding to the red sub-pixel is less than or equal to that of the storage capacitor corresponding to the green sub-pixel, and the electrode width of the storage capacitor corresponding to the green sub-pixel is less than or equal to that of the storage capacitor corresponding to the blue sub-pixel. The data shows that the planarization layers corresponding to the red sub-pixel, the green sub-pixel and the blue sub-pixel have different flatness, which satisfies |(Fᵢ-Fⱼ)/(Fᵢ+Fⱼ)|*100% ≤ 10%, where i and j both represent one of the red sub-pixel, the green sub-pixel and the blue sub-pixel. The flatness x of the planarization layer and the area ratio y of the electrode satisfy y = ax²+bx+c, where a<0, b>0 and c>0, and a ranges from 0 to -30, b ranges from 20 to 60, c ranges from 0 to 40, y is an analog value, and y_real is a measured value, in which |y-y_real|/y_real<10%.

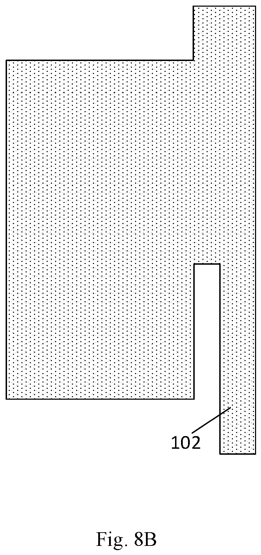

For example, Fig. 8B is a schematic plan view of a single layer of an active layer in Fig. 8A, and Fig. 8C is a schematic diagram of a plane structure in which the active layer, the gate electrode and a part of the data line in Fig. 8A are superimposed. As illustrated by Fig. 8B, the active layer 102 has a whole layer structure, which includes a left rectangle shape and a right elongated shape, and the left rectangle shape and the right elongated shape are connected into an integrated structure. As illustrated by Fig. 8C, in the plan structure in which the active layer 102 and the gate electrode 103 are superimposed, both branches of the gate electrode 103 have overlapping parts with the elongated shape of the active layer 102, and a part of the gate electrode parallel to the two branches also has an overlapping part with the elongated shape of the active layer 102, and a part of the data line, that is, the second sub-data line 114b, is also arranged in the same layer as the gate electrode 103.

For example, as illustrated by Fig. 8A, the first color sub-pixel 121, the second color sub-pixel 122 and the third color sub-pixel 123 are red sub-pixel, green sub-pixel and blue sub-pixel, respectively. In order to match the service life of the organic light emitting diode which emits blue light, the pixel area of the blue sub-pixel is increased, the power voltage signal line 127 shared by the red sub-pixel, the green sub-pixel, and the blue sub-pixel is arranged at a corresponding position of the blue sub-pixel. At the same time, in order to increase the step difference of bank between adjacent sub-pixels and prevent cross-color between adjacent sub-pixels, the power voltage signal line 127 and the data line 114 are designed to have a double-layer structure in the pixel areas corresponding to the sub-pixels, one layer of the double-layer structure is arranged in the same layer as the gate electrode 103, and the other layer of the double-layer structure is arranged in the same layer as the source-drain electrode layer 104. The single-layer structure of the power voltage signal line 127 which is arranged in the same layer as the source-drain electrode layer 104 is continuously routed in a single sub-pixel area, and the single-layer structure of the data line 114 which is arranged in the same layer as the source-drain electrode layer 104 is also continuously routed in a single sub-pixel area. The single-layer structure of the power voltage signal line 127 which is arranged in the same layer as the gate electrode 103 is discontinuous in a single sub-pixel area, and the single-layer structure of the power voltage signal line 127 which is arranged in the same layer as the gate electrode 103 is narrowed in the pixel area, and its width is smaller than that of the single-layer structure of the power voltage signal line 127 which is arranged in the same layer as the source-drain electrode layer 104. The single-layer structure of the data line 114 which is arranged in the same layer as the gate electrode 103 is also discontinuous in a single sub-pixel area, and the single-layer structure of the data line 114 arranged in the same layer as the gate electrode 103 is narrowed in the pixel area, and its width is smaller than that of the single-layer structure of the data line 114 which is arranged in the same layer as the source-drain electrode layer 104.

In addition, because the power voltage signal line 127 and the data line 114 are both arranged in the double-layer structure, small protrusions are formed at the edge of each sub-pixel, thereby increasing the step difference of the bank between adjacent sub-pixels, and the protrusions between adjacent sub-pixels have the functions of condensing light and emitting light. The single-layer structure of the power voltage signal line 127 which is arranged in the same layer as the gate electrode 103 is disconnected in the middle, and the single-layer structure of the data line 114 which is arranged in the same layer as the gate electrode 103 is disconnected in the middle. Both the source-drain electrode layer 104 and the gate electrode 103 can be made of molybdenum metal. Setting the power voltage signal line 127 and the data line 114 into the double-layer structure can prevent the current overheating generated by the high resistance caused by thin lines made of molybdenum metal, the current overheating will lead to the phenomenon of poor electrical signal transmission.

For example, as illustrated by Fig. 9, an orthographic projection of the main body part 111a included in the pixel defining layer 111on the base substrate 101, orthographic projections of the first sub-data line 114a and the second sub-data line 114b included in the same data line 114 on the base substrate 101 are at least partially overlapped with each other. The stacked arrangement of the main body part 111a of the pixel defining layer, the first sub-data line 114a and the second sub-data line 114b can elevate the main body part 111a, so that small protrusions are formed on the pixel defining layer 111, thereby reducing the phenomenon of crosstalk between light emitted by adjacent sub-pixels.

For example, as illustrated by Fig. 9, an orthographic projection of a left small protrusion on the pixel defining layer 111 on the base substrate 101 is overlapped with an orthographic projection of the data line 114 on the base substrate 101, and an orthographic projection of a right small protrusion on the pixel defining layer 111 is overlapped with an orthographic projection of the power voltage signal line 127 on the base substrate 101, and the heights of the left small protrusion and the right small protrusion on the pixel defining layer 111 are both between 0 and 200 nanometers, the thickness of the planarization layer ranges from 2 microns to 6 microns, and the thickness of the gate electrode 103 ranges from 50 nanometers to 400 nanometers.

For example, as illustrated by Figs. 1A and 9, the thickness of the source-drain electrode layer 1041 is 2.5 to 7 times that of the gate electrode 103, for example, the thickness of the source-drain electrode layer 1041 is 2.5 times, 3 times, 3.5 times, 4 times, 5 times, 5.5 times, 6 times or 7 times that of the gate electrode 103.

It should be noted that, if the thickness of the source-drain electrode layer 1041 is less than 2.5 times that of the gate electrode 103, even if the source-drain electrode layer 1041 covers the gate electrode 103, the flatness of the planarization layer cannot be improved. If the thickness of the source-drain electrode layer 1041 is more than 7 times that of the gate electrode 103, there will be a problem that the volume of the final formed display panel is too large.

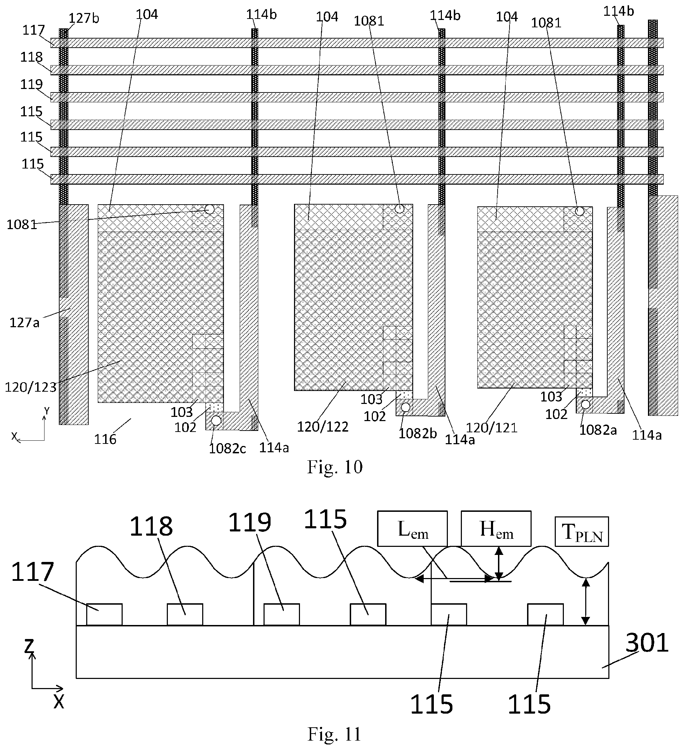

For example, Fig. 10 is a schematic plan view of another display panel provided by at least one embodiment of the present disclosure. As illustrated by Fig. 10, the display panel 100 further includes a plurality of gate lines 115, and the plurality of gate lines 115 and the plurality of data lines 114 intersect to define a plurality of pixel areas 116, and each pixel area 116 corresponds to a sub-pixel 120, that is, a first color sub-pixel, a second color sub-pixel and a third color sub-pixel are respectively arranged in their corresponding pixel areas 116.

For example, as illustrated by Fig. 10, the plurality of gate lines 115 and the source-drain electrode layer 1041 are arranged in the same layer, and the gate line 115 intersects with the second sub-data line 114a, and the gate line 115 and the first sub-data line 114a are spaced from each other, as long as the intersection of the gate line 115 and the data line 114 can be ensured, alternately, the gate line 115 intersects with the first sub-data line 114a, and the gate lines 115 and the second sub-data line 114a are spaced from each other, it is also possible that the gate line 115 intersects with the first sub-data line 114a and the second sub-data line 114b, and the embodiment of the present disclosure is not limited thereto.

For example, as illustrated by Fig. 10, the display panel 100 further includes a first initial signal line 117, a second initial signal line 118, and a power voltage connection line 119, the power voltage connection line 119 is configured to connect the power voltage signal lines 127, thereby connecting a plurality of power voltage signal lines 127 into a whole. For example, the first initial signal line 117, the second initial signal line 118 and the power voltage connection line 119 are all arranged in the same layer as the source-drain electrode layer 1041, so that the first initial signal line 117, the second initial signal line 118 and the power voltage connection line 119 can be formed in the same process step as the source-drain electrode layer 1041, and the first initial signal line 117, the second initial signal line 118 and the power voltage connection line 119 are all arranged in parallel with the gate line 115.

For example, in one example, the line width of the first initial signal line 117 is 4.84 microns, the line width of the second initial signal line 118 is 3.3 microns, the line width of the power voltage connection line 119 is 6.16 microns, the line width of the gate line 115 close to the power voltage connection line 119 is 6.6 microns, the line width of the gate line 115 in the middle position is 3.3 microns, and the line width of the gate line 115 close to the pixel area 116 is 3.96 microns. And the spacing between the first initial signal line 117 and the second initial signal line 118 is 4.4 microns, the spacing between the second initial signal line 118 and the power voltage connection line 119 is 3.3 microns, the spacing between the power voltage connection line 119 and the gate line 115 close to the power voltage connection line 119 is 3.74 microns, and the spacing between the gate line 115 close to the power voltage connection line 119 and the gate line 115 in the middle is 5.06 microns, the spacing between the gate line 115 in the middle and the gate line 115 close to the pixel area 116 is 4.4 microns. Of course, the embodiment of the present disclosure is not limited thereto, and the above-mentioned line width and spacing can be other values.

For example, Fig. 11 is a schematic cross-sectional view of a display panel provided by at least one embodiment of the present disclosure, where Wₘ represents the line width of metal lines and Sₘ represents the spacing between adjacent metal lines. Define a line width spacing ratio: K_{ws} = Wₘ/Sₘ. The planarizing layer 105 is formed on the first initial signal line 117, the second initial signal line 118, the power voltage connection line 119 and the gate line 115, and a fluctuation slope of the planarizing layer 105 is defined as Kₑₘ = Hₑₘ/Lₑₘ, Hₑₘ is the convex height of a convex part 1051, and Lₑₘ is the convex width of the convex part 1051. When the line width spacing ratio of the metal lines is 0.75, the fluctuation slope Kₑₘ of the planarizing layer 105 is 2.02; when the line width spacing ratio of the metal lines is 0.3488, the fluctuation slope Kₑₘ of the planarization layer 105 is 1.61; when the line width spacing ratio of metal lines is 0.6977, the fluctuation slope Kₑₘ of the planarization layer 105 is 2.02; when the line width spacing ratio of metal lines is 0.7568, the fluctuation slope Kₑₘ of the planarization layer 105 is 1.93; when the line width spacing ratio of the metal lines is 0.5625, the fluctuation slope Kₑₘ of the planarization layer 105 is 2.00.

For example, the relationship between the fluctuation and the line width spacing ratio is as follows.

The polynomial fitting relationship is: y = -6.19x³ + 5.4433x² + 0.7979x + 0.9289 , R² = 0.9699;
Power function: y = 2.1923x^{0.2702}, R² = 0.7982;
Logarithmic function: y = 0.4844ln(x) + 2.1641, R² = 0.7889;
Exponential function: y = 1.41e^{0.4867x}, R² = 0.7218;
Linear function: y = 0.8717x + 1.3734, R² = 0.7125.

From the above relationship, it can be concluded that the fluctuation slope of the planarization layer 105 in the metal wiring area increases with the increase of the line width spacing ratio, and when the line width spacing ratio exceeds 0.6, the fluctuation slope of the planarization layer decreases with the increase of the line width spacing ratio, because when the line width spacing ratio of the metal lines approaches 0.5, the metal lines will cause the roughness of the planarization layer on the metal lines to be the largest, which leads to the largest fluctuation of the planarization layer on metal lines.

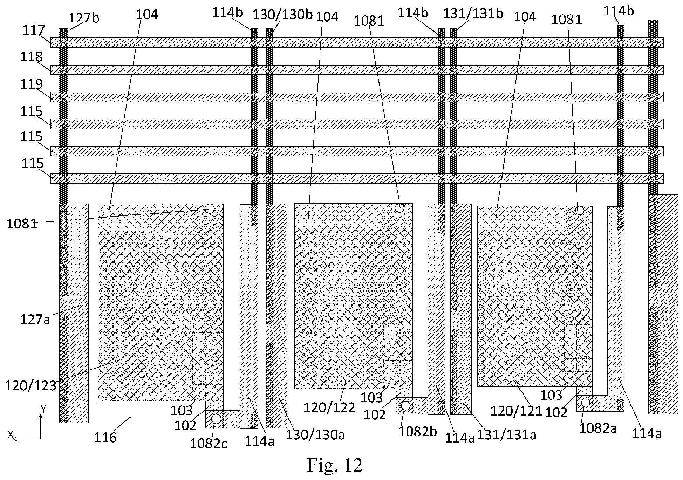

For example, Fig. 12 is a schematic plan view of another display panel provided by at least one embodiment of the present disclosure. As illustrated by Fig. 12, the display panel 100 further includes an initial signal line connection line 130, the initial signal line connection line 130 is arranged at a side of the second color sub-pixel 122 close to the third color sub-pixel 123, and the initial signal line connection line 130 and the data line 114 connected with the second color sub-pixel 122 are oppositely arranged at two sides of the second color sub-pixel 122, and the initial signal line connection line 130 intersects with the first initial signal line 117 and the second initial signal line 118.

For example, as illustrated by Fig. 12, the initial signal line connection line 130 includes a first sub-initial signal line connection line 130a and a second sub-initial signal line connection line 130b which are stacked, the first sub-initial signal line connection line 130a and the source-drain electrode layer 1041 are arranged in the same layer, the second sub-initial signal line connection line 130a and the gate electrode 103 are arranged in the same layer, and the first sub-initial signal line connection line 130a has an integral structure, and the second sub-initial signal line connection line 130b includes a fracture, which can make the current flow on the whole of the first sub-initial signal line connection line 130a, so that the area where the current flows becomes larger.

For example, as illustrated by Fig. 12, in a direction from the initial signal line connection line 130 to the data line 114 connected with the second color sub-pixel 122, the width of the first sub-initial signal line connection line 130a is greater than the width of the second sub-initial signal line connection line 130b. If a part of the second sub-initial signal line connection line 130b extending upward beyond the first sub-initial signal line connection line 130a is not considered, an orthographic projection of the second sub-initial signal line connection line 130b on the base substrate 101 is located within the orthographic projection of the first sub-initial signal line connection line 130a on the base substrate 101.

For example, as illustrated by Fig. 12, an edge of the second sub-initial signal line connection line 130b away from the second color sub-pixel 122 is aligned with an edge of the first sub-initial signal line connection line 130a away from the second color sub-pixel 122, and an edge of the second sub-initial signal line connection line 130b close to the second color sub-pixel 122 is located at a side of an edge of the first sub-initial signal line connection line 130a close to the second color sub-pixel 122 away from the second color sub-pixel 122.

For example, in one example, the width of the first sub-initial signal line connection line 130a is 2 to 3 times that of the second sub-initial signal line connection line 130b, for example, the width of the first sub-initial signal line connection line 130a is 2 times, 2.5 times or 3 times that of the second sub-initial signal line connection line 130b.

For example, in one example, the width of the first sub-initial signal line connection 130a is between 2 microns and 20 microns, and the width of the second sub-initial signal line connection 130b is between 2 microns and 10 microns. In this way, the first sub-initial signal line connection line 130a and the second sub-initial signal line connection line 130b can meet the structural features that the left edges are aligned, and the right edges are provided with a gap therebetween.

For example, in one example, the width of the first sub-initial signal line connection 130a is 4 microns, and the width of the second sub-initial signal line connection 130b is 2 microns; the width of the first sub-initial signal line connection line 130a is 8 microns, and the width of the second sub-initial signal line connection line 130b is 4 microns; the width of the first sub-initial signal line connection line 130a is 12 microns, and the width of the second sub-initial signal line connection line 130b is 6 microns; the width of the first sub-initial signal line connection line 130a is 16 microns, and the width of the second sub-initial signal line connection line 130b is 8 microns; the width of the first sub-initial signal line connection line 130a is 18 microns, and the width of the second sub-initial signal line connection line 130b is 9 microns; the width of the first sub-initial signal line connection line 130a is 20 microns, and the width of the second sub-initial signal line connection line 130b is 10 microns, so that the width of the first sub-initial signal line connection line 130a is twice that of the second sub-initial signal line connection line 130b.

For example, in one example, the width of the first sub-initial signal line connection 130a is 5 microns, and the width of the second sub-initial signal line connection 130b is 2 microns; the width of the first sub-initial signal line connection line 130a is 10 microns, and the width of the second sub-initial signal line connection line 130b is 4 microns; the width of the first sub-initial signal line connection line 130a is 15 microns, and the width of the second sub-initial signal line connection line 130b is 6 microns; the width of the first sub-initial signal line connection line 130a is 20 microns, and the width of the second sub-initial signal line connection line 130a is 8 microns, so that the width of the first sub-initial signal line connection line 130a is 2.5 times that of the second sub-initial signal line connection line 130b.

For example, in one example, the width of the first sub-initial signal line connection 130a is 9 microns, and the width of the second sub-initial signal line connection 130b is 3 microns; the width of the first sub-initial signal line connection line 130a is 12 microns, and the width of the second sub-initial signal line connection line 130b is 4 microns; the width of the first sub-initial signal line connection line 130a is 15 microns, and the width of the second sub-initial signal line connection line 130b is 5 microns; the width of the first sub-initial signal line connection line 130a is 18 microns, and the width of the second sub-initial signal line connection line 130b is 6 microns, so that the width of the first sub-initial signal line connection line 130a is three times that of the second sub-initial signal line connection line 130b.

For example, as illustrated by Fig. 12, the display panel 100 further includes a power voltage signal transmission line 131, and the power voltage signal transmission line 131 is arranged at a side of the first color sub-pixel 121 close to the second color sub-pixel 122, and the power voltage signal transmission line 131 and the data line 114 connected with the first color sub-pixel 121 are arranged at two sides of the first color sub-pixel 121 and arranged opposite to each other. For example, in the first direction X, the overall width of the power voltage signal transmission line 131 is smaller than the overall width of the power voltage signal line 127.

For example, as illustrated by Fig. 12, in one example, the power voltage signal transmission line 131 includes a first power voltage signal transmission line 131a and a second power voltage signal transmission line 131b which are stacked, the first power voltage signal transmission line 131a and the source-drain electrode layer 104 are arranged in the same layer, the second power voltage signal transmission line 131b and the gate electrode 103 are arranged in the same layer, and the first power voltage signal transmission line 131a has an integral structure, and the second power voltage signal transmission line 1331b includes a fracture. Through the above-mentioned arrangement in the same layer, even if the first power voltage signal transmission line 131a and the second power voltage signal transmission line 131b are arranged in a double-layer structure, the degree of the formed step difference will not be increased, but new step difference will be formed at a different position, so that the flatness of the planarization layer 105 will not be affected.

For example, as illustrated by Fig. 12, the first power voltage signal transmission line 131a and the second power voltage signal transmission line 131b which are stacked can reduce the resistance of the power voltage signal transmission line 131, and the second power voltage signal transmission line 131b includes a fracture to make the first power voltage signal transmission line 131a on the upper layer electrically conductive. The fracture on the second power voltage signal transmission line 131b can make the current flow on the whole of the first power voltage signal transmission line 131a, so that the area where the current flows becomes larger.

For example, as illustrated by Fig. 12, in a direction from the power voltage signal transmission line 131 to the data line 114 connected with the first color sub-pixel 121, the width of the first power voltage signal transmission line 131a is greater than the width of the second power voltage signal transmission line 131b. If a part of the second power voltage signal transmission line 131b extending upward beyond the first power voltage signal transmission line 131a is not considered, an orthographic projection of the second power voltage signal transmission line 131b on the base substrate 101 is located within an orthographic projection of the first power voltage signal transmission line 131a on the base substrate 101.

For example, in one example, an edge of the second power voltage signal transmission line 131b away from the data line 114 connected with the first color sub-pixel 121 is aligned with an edge of the first power voltage signal transmission line 131a away from the data line 114 connected with the first color sub-pixel 131. And, an edge of the second power voltage signal transmission line 131b close to the data line 114 connected with the first color sub-pixel 121 is located at a side of an edge of the first power voltage signal transmission line 131a close to the data line 114 connected with the first color sub-pixel 121 away from the data line 114 connected with the first color sub-pixel 121.

For example, in one example, the width of the first power voltage signal transmission line 131a is 2 to 3 times that of the second power voltage signal transmission line 131b, for example, the width of the first power voltage signal transmission line 131a is 2 times, 2.5 times or 3 times that of the second power voltage signal transmission line 131b.

For example, in one example, the width of the first power voltage signal transmission line 131a is between 2 microns and 30 microns, and the width of the second power voltage signal transmission line 131b is between 2 microns and 10 microns. In this way, the first power voltage signal transmission line 131a and the second power voltage signal transmission line 131b can meet the structural features that the left edges are aligned, and the right edges are provided with a gap therebetween.

For example, in one example, the width of the first power voltage signal transmission line 131a is 4 microns, and the width of the second power voltage signal transmission line 131b is 2 microns; the width of the first power voltage signal transmission line 131a is 8 microns, and the width of the second power voltage signal transmission line 131b is 4 microns; the width of the first power voltage signal transmission line 131a is 12 microns, and the width of the second power voltage signal transmission line 131b is 6 microns; the width of the first power voltage signal transmission line 131a is 16 microns, and the width of the second power voltage signal transmission line 131b is 8 microns; the width of the first power voltage signal transmission line 131a is 18 microns, and the width of the second power voltage signal transmission line 131b is 9 microns; the width of the first power voltage signal transmission line 131a is 20 microns, and the width of the second power voltage signal transmission line 131b is 10 microns, so that the width of the first power voltage signal transmission line 131a is twice that of the second power voltage signal transmission line 131b.

For example, in one example, the width of the first power voltage signal transmission line 131a is 5 microns, and the width of the second power voltage signal transmission line 131b is 2 microns; the width of the first power voltage signal transmission line 131a is 10 microns, and the width of the second power voltage signal transmission line 131b is 4 microns; the width of the first power voltage signal transmission line 131a is 15 microns, and the width of the second power voltage signal transmission line 131b is 6 microns; the width of the first power voltage signal transmission line 131a is 20 microns, and the width of the second power voltage signal transmission line 131b is 8 microns, so that the width of the first power voltage signal transmission line 131a is 2.5 times that of the second power voltage signal transmission line 131b.

For example, in one example, the width of the first power voltage signal transmission line 131a is 9 microns, and the width of the second power voltage signal transmission line 131b is 3 microns; the width of the first power voltage signal transmission line 131a is 12 microns, and the width of the second power voltage signal transmission line 131b is 4 microns; the width of the first power voltage signal transmission line 131a is 15 microns, and the width of the second power voltage signal transmission line 131b is 5 microns; the width of the first power voltage signal transmission line 131a is 18 microns, and the width of the second power voltage signal transmission line 131b is 6 microns, so that the width of the first power voltage signal transmission line 131a is three times that of the second power voltage signal transmission line 131b.

For example, as illustrated by Fig. 12, the data line 114 extends in the first direction X, the gate line 115 extends in the second direction Y, and the first direction X and the second direction Y are perpendicular to each other.

For example, as illustrated by Fig. 12, in the first direction X, the width of the first power voltage signal line 127a is W1, the width of the first sub-data line 114a is W2, the width of the first sub-initial signal line connection line 130a is W3, the width of the source-drain electrode layer 1041 corresponding to the third color sub-pixel 123 is W4, the width of the source-drain electrode layer 1041 corresponding to the second color sub-pixel 122 is W5, the width of the source-drain electrode layer 1041 corresponding to the first color sub-pixel 121 is W6, the width of a first gap D1 between the first sub-initial signal line connection line 130a and the second color sub-pixel 122 is W7, a spacing between the second color sub-pixel 122 and the first power voltage signal transmission line 131a is W8, and the width of the first power voltage signal transmission line 131a is W9, W1 is equal to or approximately equal to W4, |W1-W4|/|W1 +W4|≤0.05, (W2+W3)/min(W4, W5, W6)≤0.05, (W2+ W3)/min(W4, W5, W6)≤0.5, (W2+W9)/min(W4, W5, W6)≤0.5, W7/min(W4, W5, W6)≤0.5, W8/min(W4, W5, W6)≤0.05, |W8-W7|/min(W4, W5, W6) ≤0.25, |W8-W7|/|W8+W7|≤0.4.

For example, in one example, the line width spacing ratio K_{ws} of each gate line 115 satisfies K_{ws}= Wₘ/Sₘ, where Wₘ is the line width of the gate line 115, Sₘ is the spacing between adjacent gate lines 115, and the value of K_{ws} is in the range of 0 to 1; the fluctuation slope Kₑₘ of the convex part 1051 of the planarization layer 105 corresponding to each gate line 115 satisfies Kₑₘ = Hₑₘ/Lₑₘ, where Hₑₘ is the convex height of the convex part 1051 and Lₑₘ is the convex width of the convex part 1051, and the value of Kₑₘ is in the range of 1 to 2; the fluctuation slope Kₑₘ of the planarization layer 105 and the line width spacing ratio K_{ws} of the gate line 115 satisfy Kₑₘ= aK_{ws}³ +bK_{ws}²+ cK_{ws} +d, where a ranges from - 20 to 0, b ranges from 0 to 20, c ranges from -10 to 10, and d ranges from -10 to 10.

For example, in one example, the formula obtained by polynomial fitting of the fluctuation slope Kₑₘ of the planarization layer 105 and the line width spacing ratio K_{ws} of the gate line 115 is Kₑₘ=-5.5036K_{ws}³+4.8397K_{ws}²+0.7095K_{ws}+0.8259, and the determination coefficient R² = 0.9699.

For example, as illustrated by Fig. 12, the width of the first power voltage signal line 127a is W1=30µm, the width of the storage capacitor of the blue sub-pixel is 30µm, the maximum width of the data line is 3µm, the width of the first sub-initial signal line connection line 130a is 5µm, and the width of the storage capacitor of the green sub-pixel is 25µm, the spacing between the edge of the green sub-pixel close to the first sub-initial signal line connection line 130a and the first sub-initial signal line connection line 130a is 5µm, the spacing between the edge of the green sub-pixel close to the red sub-pixel and the first power voltage signal transmission line 131a is 10µm, the width of the first power voltage signal transmission line 131a is 5µm, and the width of the storage capacitor of the red sub-pixel is 25µm. By designing the above-mentioned line width and spacing, the flatness of the planarization layer can be improved, so that the problem of color deviation can be improved.

For example, as illustrated by Fig. 12, an electrode block in the capacitor area of the first source-drain electrode 1041 is used to improve the flatness of the planarization layer 105, and the film layer of the first source-drain electrode 1041 is relatively thick, and the first source-drain electrode 1041 is close to the planarization layer 105, which is beneficial to improving the flatness of the planarization layer 105, and the material of the gate line is the same as that of the source-drain electrode layer.

For example, as illustrated by Fig. 12, a light shielding layer can be removed, so that the process steps and the amount of metal materials can be further reduced to reduce the production cost, and one longitudinal initial signal line connection line 130 and one longitudinal power voltage signal transmission line 131 are respectively added to form a plurality of grid lines formed by the intersections of the power voltage signal transmission line 131, the power voltage signal line 127 and the power voltage connection line 119, and the resistance and voltage drop are reduced, the grid line of the initial signal line is formed to reduce the resistance and voltage drop, so as to guarantee the stable initialization voltage. For example, in another example, the double-layer wiring of data line is not used in the pixel area, but the longitudinal initial signal line connection line 130 and the longitudinal power voltage signal transmission line 131 designed at the pixel boundary are designed to use double-layer wiring, in which one layer of the double-layer wiring is arranged in the same layer as the gate electrode, the other layer of the double-layer wiring is arranged in the same layer as the first source-drain electrode, and the structure arranged in the same layer as the gate electrode is disconnected in the pixel central area. Because the initial signal line connection line 130 and the power voltage signal transmission line 131 are used as pixel boundaries, the thickness needs to be increased to improve the step difference of the pixel boundary (Bank).

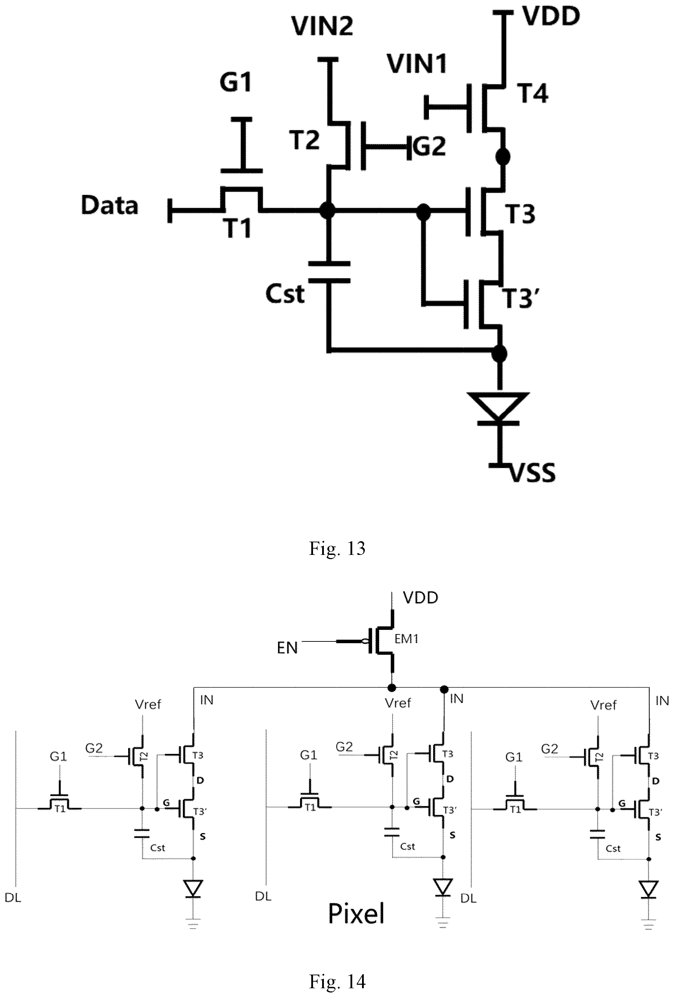

For example, Fig. 13 is a schematic diagram of a circuit structure of a display panel provided by at least one embodiment of the present disclosure. As illustrated by Fig. 13, the gate electrode of the first thin film transistor T1 is controlled by the gate line G1 and connected with the data line Data, and the gate line G1 turns on the first thin film transistor T1 to input the data signal Data to the gate electrode of the third thin film transistor T3 and store data signal Data in the storage capacitor Cst. The gate electrode of the second thin film transistor T2 is controlled by the gate line G2 and connected with the second initial signal line VIN2, the second thin film transistor T2 is turned on during one frame of image, the gate voltage of the third thin film transistor T3 stored in the previous frame of image is erased, and the initial signal line VIN2 is written to the gate electrode of the driving transistor T3. Because the third thin film transistor T3 is a driving transistor, which has a driving function and needs a relatively small transistor width-length ratio, that is, the length of the channel is relatively large, so two transistors T3 and T3' are provided, and the gate electrode is disconnected in the middle in the plan view shown in Fig. 8C, but the gate electrode is connected together as a whole. The drain electrode of the driving transistor T3 is connected with the pixel electrode, and then the pixel electrode is connected with the light emitting diode. The source electrode of the driving transistor T3 is connected with the fourth thin film transistor T4, the gate electrode of the fourth thin film transistor T4 is controlled by the first initial signal line VIN1, and the source electrode of the fourth thin film transistor T4 is connected with the power voltage signal line.

For example, Fig. 14 is a schematic diagram of a circuit structure of another display panel provided by at least one embodiment of the present disclosure. In Fig. 14, the transistor EM1 can be regarded as the fourth thin film transistor T4, and FN can be regarded as the first initial signal line VIN1. For the working principles of other transistors, please refer to the related description in the above-mentioned Fig. 13.

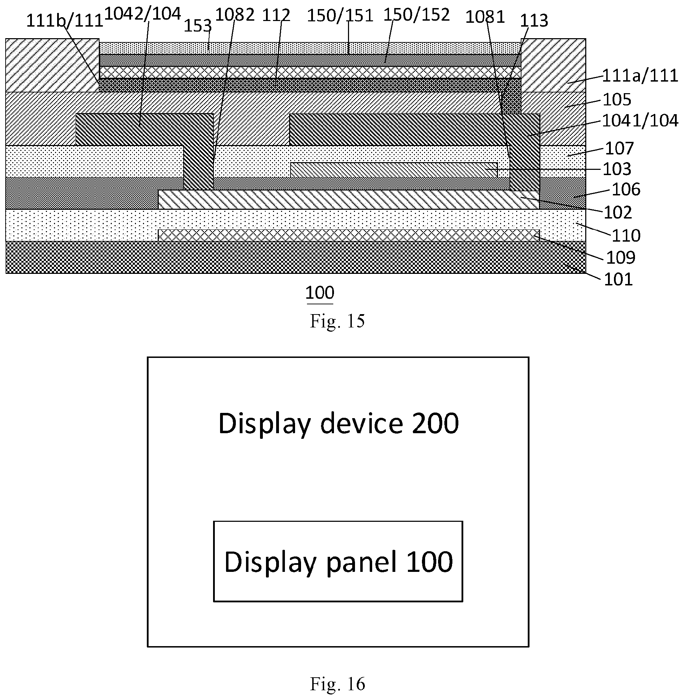

For example, Fig. 15 is a schematic cross-sectional structure diagram of another display panel provided by at least one embodiment of the present disclosure. As illustrated by Fig. 15, the display panel 100 further includes a light emitting element 150 and a second electrode 153 arranged at the side of the first electrode 112 away from the base substrate 101. The light emitting element 150 includes a light emitting layer 151 and an organic functional layer 152 stacked with the light emitting layer 151. For example, in one example, the light emitting layer 151 is formed by a printing process, and the organic functional layer 152 is formed by a vapor deposition process.

For example, as illustrated by Fig. 15, the light emitting element 150 includes a red light emitting element, a green light emitting element and a blue light emitting element, a ratio of the thickness of the red light emitting layer included by the red light emitting element to the peak wavelength of red light ranges from 0.15 to 0.4, and a ratio of the thickness of the green light emitting layer included by the green light emitting element to the peak wavelength of green light ranges from to; and a ratio of the thickness of the blue light emitting layer 1501c included by the blue light emitting element to the peak wavelength of blue light ranges from 0.1 to 0.2.

For example, because blue light has the shortest wavelength and the highest energy, and the exciton quenching coefficient of blue light emitting material is the highest, the thinner the blue light emitting layer, the better.

For example, in one example, the first electrode 112 has a three-layer structure, the upper layer and the lower layer of the first electrode 112 are electrode layers made of tungsten oxide, and the middle layer sandwiched between the upper layer and the lower layer is made of aluminum, the thickness of the middle layer ranges 180 nm to 191 nm. The thickness of the electrode layer close to the second electrode 153 in the upper layer and the lower layer ranges from 11 nm to 14 nm, and the thickness of the other layer in the upper layer and the lower layer ranges from 4 nm to 7 nm. The second electrode 153 has a double-layer structure, in which a layer close to the first electrode 112 is made of indium oxide with a thickness of 79 nm to 81 nm. The material of the layer away from the first electrode 112 in the double-layer structure is silver, and its thickness is 13 nm to 17 nm. The organic functional layer includes a hole transport layer, a hole injection layer and an electron injection layer. The electron injection layer has a double-layer structure, and the thickness of the layer of the electron injection layer close to the first electrode 112 is 3 nm to 7 nm, and the thickness of the layer of the electron injection layer away from the first electrode 112 is 25 nm to 27 nm.

For example, in one example, the first electrode 112 has a double-layer structure, and a layer of the first electrode 112 close to the second electrode 153 is made of tungsten oxide with a thickness of 12 nm, and a layer of the first electrode 112 away from the second electrode 153 is made of aluminum metal with a thickness of 248 nm. The thickness of the layer structure of the electron injection layer close to the first electrode 112 is 7 nm, the thickness of the layer structure of the electron injection layer away from the first electrode 112 is 8 nm, the material of the second electrode 153 is silver metal, and its thickness is 26 nm, and a packaging layer is arranged at a side of the second electrode 153 away from the first electrode 112.

For example, in one example, a ratio of the thickness of the red light emitting layer formed by printing in the red sub-pixel to the red peak wavelength ranges from 0.15 to 0.4. A ratio of the thickness of the green light emitting layer formed by printing in the green sub-pixel to the green peak wavelength ranges from 0.15 to 0.3. A ratio of the thickness of the thickness of the blue light emitting layer formed by printing in the blue sub-pixel to the blue peak wavelength ranges from 0.1 to 0.2. The wavelength of the blue light is 456.6nm, the wavelength of the green light is 528.73nm, and the wavelength of the red light is 619.47nm.

For example, in one example, the ratio of the thickness of the red light emitting layer formed by printing in the red sub-pixel to the wavelength of the red light is 0.2776, and a ratio of a sum of the thicknesses of the red light emitting layer and the organic functional layer which are formed by printing in the red sub-pixel to the wavelength of the red light is 0.3244. The ratio of the thickness of the green light emitting layer formed by printing in the green sub-pixel to the wavelength of green light is 0.2118, and the ratio of a sum of the thicknesses of the green light emitting layer and the organic functional layer which are formed by printing in the green sub-pixel to the wavelength of green light is 0.2667. The ratio of the thickness of the blue light emitting layer formed by printing in the blue sub-pixel to the wavelength of blue light is 0.1533, and the ratio of a sum of the thicknesses of the blue light emitting layer and the organic functional layer which are formed by printing in the blue sub-pixel to the wavelength of blue light is 0.2168.

For example, in another example, the ratio of the thickness of the red light emitting layer formed by printing in the red sub-pixel to the wavelength of the red light is 0.2034, and the ratio of a sum of the thicknesses of the red light emitting layer and the organic functional layer which are formed by printing in the red sub-pixel to the wavelength of the red light is 0.2276. The ratio of the thickness of the green light emitting layer formed by printing in the green sub-pixel to the wavelength of green light is 0.1872, and the ratio of a sum of the thickness of the green light emitting layer and the organic functional layer which are formed by printing in the green sub-pixel to the wavelength of green light is 0.2156. The ratio of the thickness of the blue light emitting layer formed by printing in the blue sub-pixel to the wavelength of blue light is 0.1424, and the ratio of a sum of the thicknesses of the blue light emitting layer and the organic functional layer which are formed by printing in the blue sub-pixel to the wavelength of blue light is 0.1752.

For example, in one example, a ratio of a sum of the thicknesses of a plurality of red light emitting layers 1501a and corresponding organic functional layers 152 (red organic functional layers 152a) to the peak wavelength of red light ranges from 0.2 to 0.4; a ratio of a sum of the thicknesses of a plurality of green light emitting layers 1501b and corresponding organic functional layers 152 (green organic functional layers 152b) to the peak wavelength of green light ranges from 0.2 to 0.3; a ratio of a sum of the thicknesses of a plurality of blue light emitting layers and corresponding organic functional layers 152 (blue organic functional layers 152c) to the peak wavelength of blue light ranges from 0.15 to 0.25.

For example, the evaporation process can form thin films or small molecules layer by layer on the base substrate by physical deposition, so the uniformity of the printing process is worse than that of the evaporation process. Usually, the light emitting layer is formed on the structure in which the first electrode/planarization layer/thin film transistor are sequentially stacked. Therefore, the light emitting layer formed by evaporation process has good conformal characteristics, and has the same or very close thickness everywhere on the above-mentioned stacked structure. In the printing process, a liquid with fluid properties and viscous viscosity is dripped through the nozzle, so the concave part and the convex part in the stacked structure will form different thicknesses, resulting in poor uniformity of film thickness. However, the structure of light emitting layers with different thicknesses at different positions may lead to inconsistent light emitting characteristics and color deviation. In order to improve the above characteristics, the embodiment of the present disclosure adjusts the arrangement and line width of signal lines in different color pixel areas.

That is, the embodiment of the present disclosure improves the flatness of the planarization layer by adjusting the line widths of various signal lines, such as the first initial signal line, the second initial signal line, the power voltage connection line and the gate line or the spacing between adjacent signal lines.

For example, at least one embodiment of the present disclosure also provides a display device, which includes any one of the display panels mentioned above. For example, Fig. 16 is a block diagram of the display device provided by at least one embodiment of the present disclosure, and as illustrated by Fig. 16, the display device 200 includes the display panel 100. For example, the display panel 100 may be a display panel provided by any one of the embodiments of the present disclosure.

For example, the display device 200 may be a display device with a display function. For example, the display device 200 can be a display, an OLED display panel, an OLED TV, a liquid crystal display panel, an LCD TV, a QLED display panel, a QLED TV, an electronic paper, a mobile phone, a tablet computer, a notebook computer, a digital photo frame, a navigator and any other products or components with display function and touch function.

The display panel and the display device provided by at least one embodiment of the present disclosure have at least one of the following beneficial technical effects:
(1) In the display panel provided by at least one embodiment of the present disclosure, the orthographic projection of the gate electrode on the base substrate is located within the orthographic projections of the source-drain electrode layer and the active layer on the base substrate, and the thickness of the source-drain electrode layer is greater than that of the gate electrode in the direction perpendicular to the main surface of the base substrate. By designing the gate electrode, the source-drain electrode layer and the active layer to have the above-mentioned structural relationship, the flatness of the planarization layer on the source-drain electrode layer can be improved, that is, the surface of the planarization layer can be made flatter, which can improve the display effect of the display panel.
(2) In the display panel provided by at least one embodiment of the present disclosure, the power voltage signal line includes a first power voltage signal line and a second power voltage signal line which are stacked, the first power voltage signal line and the source-drain electrodes are arranged in the same layer, the second power voltage signal line and the gate electrode are arranged in the same layer, and the first power voltage signal line has an integral structure, and the second power voltage signal line includes a fracture, which can make the current flow on the whole of the first power voltage signal line, so that the area where the current flows becomes larger.
(3) In the display panel provided by at least one embodiment of the present disclosure, because both the power voltage signal line and the data line are arranged in a double-layer structure, small protrusions are formed at the edges of each sub-pixel, thereby increasing the step difference of the bank between adjacent sub-pixels, and the protrusions between adjacent sub-pixels have the functions of focusing light and emitting light.

The following statements should be noted:
(1) The drawings involve only the structure(s) in connection with the embodiment(s) of the present disclosure, and other structure(s) can be referred to common design(s).
(2) For clarity, in the drawings used to describe the embodiments of the present disclosure, the thicknesses of the layers or regions are enlarged or reduced, which means that these drawings are not drawn to actual proportions.
(2) In case of no conflict, features in one embodiment or in different embodiments can be combined to obtain new embodiments.

The above is only the specific embodiment of the present disclosure, but the protection scope of the present disclosure is not limited thereto. Therefore, the scope of protection of the present disclosure should be based on the scope of protection of the claims.

## Claims

1. A display panel, comprising:
a base substrate;
an active layer, a gate electrode and a source-drain electrode layer which are sequentially stacked on the base substrate; and
a planarization layer, arranged at a side of the source-drain electrode layer away from the base substrate,
wherein an orthographic projection of the gate electrode on the base substrate is located within orthographic projections of the source-drain electrode layer and the active layer on the base substrate, and in a direction perpendicular to a main surface of the base substrate, a thickness of the source-drain electrode layer is greater than a thickness of the gate electrode.

2. The display panel according to claim 1, wherein,
a gate insulating layer is arranged between the active layer and the gate electrode, and an interlayer insulating layer is arranged between the gate electrode and the source-drain electrode layer;
the source-drain electrode layer comprises a first source-drain electrode and a second source-drain electrode which are oppositely arranged;
the first source-drain electrode is electrically connected with the active layer through a first via hole structure that sequentially penetrates the interlayer insulating layer and the gate insulating layer, and an orthographic projection of the gate electrode on the base substrate is located within an orthographic projection of the first source-drain electrode on the base substrate;
the second source-drain electrode is electrically connected with the active layer through a second via hole structure that sequentially penetrates the interlayer insulating layer and the gate insulating layer.

3. The display panel according to claim 2, wherein an end portion of the first source-drain electrode away from the second source-drain electrode is electrically connected with the active layer through the first via hole structure.

4. The display panel according to claim 2, further comprising a plurality of data lines, wherein the plurality of data lines are arranged in the same layer as the source-drain electrode layer, and the plurality of data lines are electrically connected with corresponding second source-drain electrodes.

5. The display panel according to claim 4, further comprising a pixel defining layer arranged at a side of the planarization layer away from the base substrate, wherein the pixel defining layer comprises a main body part and an opening area between adjacent main body parts.

6. The display panel according to claim 5, further comprising a first electrode arranged at a side of the planarization layer away from the base substrate, wherein the first electrode is arranged in the opening area, and the first electrode is electrically connected with the first source-drain electrode through a third via hole structure penetrating through the planarization layer.

7. The display panel according to any one of claims 4 to 6, comprising a plurality of sub-pixels, wherein the plurality of sub-pixels comprise a first color sub-pixel, a second color sub-pixel and a third color sub-pixel which are sequentially and adjacently arranged, an orthographic projection of the first source-drain electrode corresponding to the first color sub-pixel on the base substrate has a first metal area S_{M1}, an orthographic projection of the first source-drain electrode corresponding to the second color sub-pixel on the base substrate has a second metal area S_{M2}, and an orthographic projection of the first source-drain electrode corresponding to the third color sub-pixel on the base substrate has a third metal area S_{M3}, the first metal area S_{M1} is less than or equal to the second metal area S_{M2}, and the second metal area S_{M2} is less than the third metal area S_{M3}.

8. The display panel according to claim 7, wherein the first color sub-pixel, the second color sub-pixel and the third color sub-pixel are red sub-pixel, green sub-pixel and blue sub-pixel, respectively, and the first color sub-pixel has a first sub-pixel area S_{P1}, the second color sub-pixel has a second sub-pixel area S_{P2} and the third color sub-pixel has a third sub-pixel area S_{P3}, F1= S_{M1}/S_{P1}, F2= S_{M2}/S_{P2}, F3= S_{M3}/S_{P3}, and F1, F2 and F3 are respectively an area ratio of the first source-drain electrode corresponding to the first color sub-pixel, an area ratio of the first source-drain electrode corresponding to the second color sub-pixel and an area ratio of the first source-drain electrode corresponding to the third color sub-pixel, and F1 is greater than or equal to F2, and F2 is greater than F3.

9. The display panel according to claim 8, wherein the area ratio F1 of the first source-drain electrode corresponding to the first color sub-pixel, the area ratio F2 of the first source-drain electrode corresponding to the second color sub-pixel and the area ratio F3 of the first source-drain electrode corresponding to the third color sub-pixel are 55%, 50% and 30%, respectively.

10. The display panel according to any one of claims 7 to 9, wherein the plurality of sub-pixels are arranged in an array, in a row direction, a width of the first source-drain electrode corresponding to the first color sub-pixel is less than or equal to a width of the first source-drain electrode corresponding to an adjacent second color sub-pixel, and the width of the first source-drain electrode corresponding to the second color sub-pixel is less than or equal to a width of the first source-drain electrode corresponding to an adjacent third color sub-pixel.

11. The display panel according to any one of claims 7 to 10, wherein different positions of the planarization layer have different flatness, and the flatness of the planarization layer increases with a decrease of area ratios of first source-drain electrodes corresponding to the plurality of sub-pixels.

12. The display panel according to claim 11, wherein a first flatness F_{P1} of the planarization layer corresponding to the first color sub-pixel is less than or equal to a second flatness F_{P2} of the planarization layer corresponding to the second color sub-pixel, and the second flatness F_{P2} of the planarization layer corresponding to the second color sub-pixel is less than or equal to a third flatness F_{P3} of the planarization layer corresponding to the third color sub-pixel.

13. The display panel according to claim 12, wherein the first flatness F_{P1}=(H1-H1')/T, the second flatness F_{P2}=(H2-H2')/T, the third flatness F_{P3}=(H3-H3')/T, and H1 and H1' respectively are a maximum thickness and a minimum thickness of the planarization layer corresponding to the first color sub-pixel; H2 and H2' respectively are a maximum thickness and a minimum thickness of the planarization layer corresponding to the second color sub-pixel; H3 and H3' respectively are a maximum thickness and a minimum thickness of the planarization layer corresponding to the third color sub-pixel, respectively; T is an average thickness of the planarization layer.

14. The display panel according to claim 12, wherein |(F_{P1}-F_{P2})/(F_{P1}+F_{P2})|*100%≤10%, |(F_{P1}-F_{P3})/(F_{P1}+F_{P3})}|*100%≤ 10%, and |(F_{P2}-F_{P3})/(F_{P2}+F_{P3})|*100%≤10%.

15. The display panel according to any one of claims 11 to 14, wherein a formula obtained by polynomial fitting an average flatness x of the planarization layer and the area ratios y of the first source-drain electrodes corresponding to the plurality of sub-pixels is y=ax2+bx+c, and a ranges from 0 to -30, b ranges from 20 to 60, and c ranges from 0 to 40.

16. The display panel according to claim 15, wherein the formula obtained by polynomial fitting the average flatness x of the planarization layer and the area ratios y of the first source-drain electrodes corresponding to the plurality of sub-pixels is y = -10.541x² + 37.449x + 7.7342, and a determination coefficient R² = 1.

17. The display panel according to any one of claims 12 to 14, wherein the first flatness F_{P1}, the second flatness F_{P2} and the third flatness F_{P3} are 1.5%, 2% and 2.5%, respectively.

18. The display panel according to any one of claims 12 to 17, further comprising a power voltage signal line, wherein the power voltage signal line is arranged at a side of the third color sub-pixel away from the second color sub-pixel.

19. The display panel according to claim 18, wherein the power voltage signal line comprises a first power voltage signal line and a second power voltage signal line which are stacked, the first power voltage signal line and the source-drain electrode layer are arranged in the same layer, the second power voltage signal line and the gate electrode are arranged in the same layer, and the first power voltage signal line has an integral structure, and the second power voltage signal line comprises a fracture.

20. The display panel according to claim 19, wherein the power voltage signal line and a data line connected with the third color sub-pixel are respectively arranged at two sides of the third color sub-pixel, and the power voltage signal line and the data line connected with the third color sub-pixel are oppositely arranged, and in a direction from the power voltage signal line to the data line connected with the third color sub-pixel, a width of the first power voltage signal line is larger than a width of the second power voltage signal line.

21. The display panel according to claim 19 or 20, wherein an edge of the second power voltage signal line away from the data line connected with the third color sub-pixel is aligned with an edge of the first power voltage signal line away from the data line connected with the third color sub-pixel, and an edge of the second power voltage signal line close to the data line connected with the third color sub-pixel is located at a side of an edge of the first power voltage signal line close to the data line connected with the third color sub-pixel away from the data line connected with the third color sub-pixel.

22. The display panel according to claim 20 or 21, wherein the width of the first power voltage signal line is 2 to 4 times the width of the second power voltage signal line.

23. The display panel according to claim 22, wherein the width of the first power voltage signal line is 10 to 30 microns, and the width of the second power voltage signal line is 2 to 20 microns.

24. The display panel according to claim 19, wherein an orthographic projection of the main body part of the pixel defining layer on the base substrate and an orthographic projection of the first power voltage signal line on the base substrate, and an orthographic projection of the second power voltage signal line on the base substrate are at least partially overlapped with each other.

25. The display panel according to any one of claims 18 to 24, wherein each of the plurality of data lines comprises a first sub-data line and a second sub-data line which are stacked, the first sub-data line and the source-drain electrode layer are arranged in the same layer, the second sub-data line and the gate electrode are arranged in the same layer, the first sub-data line has an integral structure, the second sub-data line comprises a fracture, and each of the data lines is electrically connected with the first source-drain electrode of a corresponding sub-pixel through the first sub-data line.

26. The display panel according to claim 25, wherein in a direction from the power voltage signal line to the data line connected with the third color sub-pixel, a width of the first sub-data line is greater than a width of the second sub-data line.

27. The display panel according to claim 26, wherein in the same data line of the plurality of data lines, an edge of the second sub-data line away from a sub-pixel connected with the data line is aligned with an edge of a corresponding first sub-data line away from the sub-pixel electrically connected therewith, and an edge of the second sub-data line close to the sub-pixel connected with the data line is located at a side of an edge of the corresponding first sub-data line close to the sub-pixel electrically connected therewith away from a corresponding sub-pixel.

28. The display panel according to claim 26 or 27, wherein in the same data line of the plurality of data lines, a width of the first sub data line is 2 to 4 times a width of the second sub data line.

29. The display panel according to claim 28, wherein in the same data line of the plurality of data lines, the width of the first sub-data line is 2 to 20 microns, and the width of the second sub-data line is 2 to 10 microns.

30. The display panel according to claim 27, wherein an orthographic projection of the main body part included in the pixel defining layer on the base substrate and orthographic projections of the first sub-data line and the second sub-data line included in the same data line of the plurality of data lines on the base substrate are at least partially overlapped with each other.

31. The display panel according to any one of claims 1 to 10, wherein the thickness of the source-drain electrode layer is 2.5 to 7 times the thickness of the gate electrode.

32. The display panel according to any one of claims 25 to 27, further comprising a plurality of gate lines, wherein the plurality of gate lines and the plurality of data lines intersect to define a plurality of pixel areas, and each of the plurality of pixel areas corresponds to one of the plurality of sub-pixels.

33. The display panel according to claim 32, wherein the plurality of gate lines and the source-drain electrode layers are arranged in the same layer, and the plurality of gate lines and the second sub-data lines intersect with each other, and the plurality of gate lines and the first sub-data line are spaced from each other.

34. The display panel according to claim 33, further comprising a first initial signal line, a second initial signal line and a power voltage connection line, wherein the power voltage connection line is configured to be connected with the power voltage signal line, and the first initial signal line, the second initial signal line and the power voltage connection line are all arranged in the same layer as the source-drain electrode layer and parallel to the plurality of gate lines.

35. The display panel according to claim 34, further comprising an initial signal line connection line, wherein the initial signal line connection line is arranged at a side of the second color sub-pixel close to the third color sub-pixel, the initial signal line connection line and a data line connected with the second color sub-pixel are oppositely arranged at two sides of the second color sub-pixel, and the initial signal line connection line intersects with the first initial signal line and the second initial signal line.

36. The display panel according to claim 35, wherein the initial signal line connection line comprises a first sub-initial signal line connection line and a second sub-initial signal line connection line which are stacked, the first sub-initial signal line connection line and the source-drain electrode layer are arranged in the same layer, the second sub-initial signal line connection line and the gate electrode are arranged in the same layer, the first sub-initial signal line connection line has an integral structure, and the second sub-initial signal line connection line comprises a fracture.

37. The display panel according to claim 36, wherein in a direction from the initial signal line connection line to the data line connected with the second color sub-pixel, a width of the first sub-initial signal line connection line is greater than a width of the second sub-initial signal line connection line.

38. The display panel according to claim 36, wherein an edge of the second sub-initial signal line connection line away from the second color sub-pixel is aligned with an edge of the first sub-initial signal line connection line away from the second color sub-pixel, and an edge of the second sub-initial signal line connection line close to the second color sub-pixel is located at a side of an edge of first sub-initial signal line connection line close to the second color sub-pixel away from the second color sub-pixel.

39. The display panel according to claim 37, wherein the width of the first sub-initial signal line connection line is 2 to 3 times the width of the second sub-initial signal line connection line.

40. The display panel according to claim 39, wherein the width of the first sub-initial signal line connection line is 2 to 20 microns, and the width of the second sub-initial signal line connection line is 2 to 10 microns.

41. The display panel according to any one of claims 34 to 40, further comprising a power voltage signal transmission line, wherein the power voltage signal transmission line is arranged at a side of the first color sub-pixel close to the second color sub-pixel;
the power voltage signal transmission line and a data line connected with the first color sub-pixel are arranged at two sides of the first color sub-pixel and arranged opposite to each other.

42. The display panel according to claim 41, wherein the power voltage signal transmission line comprises a first power voltage signal transmission line and a second power voltage signal transmission line which are stacked, the first power voltage signal transmission line and the source-drain electrode layer are arranged in the same layer, the second power voltage signal transmission line and the gate electrode are arranged in the same layer, and the first power voltage signal transmission line has an integral structure, and the second power voltage signal transmission line comprises a fracture.

43. The display panel according to claim 42, wherein in a direction from the power voltage signal transmission line to the data line connected with the first color sub-pixel, a width of the first power voltage signal transmission line is greater than a width of the second power voltage signal transmission line.

44. The display panel according to claim 43, wherein an edge of the second power voltage signal transmission line away from the data line connected with the first color sub-pixel is aligned with an edge of the first power voltage signal transmission line away from the data line connected with the first color sub-pixel, and an edge of the second power voltage signal transmission line close to the data line connected with the first color sub-pixel is located at a side of an edge of the first power voltage signal transmission line close to the edge of the data line connected with the first color sub-pixel away from the data line connected with the first color sub-pixel.

45. The display panel according to claim 43, wherein the width of the first power voltage signal transmission line is 2 to 3 times the width of the second power voltage signal transmission line.

46. The display panel according to claim 45, wherein the width of the first power voltage signal transmission line is between 2 microns and 30 microns, and the width of the second power voltage signal transmission line is between 2 microns and 10 microns.

47. The display panel according to any one of claims 33 to 40, wherein the data lines extend in a first direction, and the gate lines extend in a second direction, the first direction is perpendicular to the second direction.

48. The display panel according to claim 47, wherein in the first direction, the width of the first power voltage signal line is W1, the width of the first sub-data line is W2, the width of the first sub-initial signal line connection line is W3, a width of the source-drain electrode layer corresponding to the third color sub-pixel is W4, and a width of the source-drain electrode layer corresponding to the second color sub-pixel is W5, a width of the source-drain electrode layer corresponding to the first color sub-pixel is W6, a width of a first gap between the first initial signal line connection line and the second color sub-pixel is W7, a spacing between the second color sub-pixel and the first power voltage signal transmission line is W8, and the width of the first power voltage signal transmission line is W9, and W1 is equal to or approximately equal to W4, |W1-W4|/|W1+W4|≤0.05, (W2+W3)/min(W4, W5, W6)≤0.05, (W2+ W3)/min(W4, W5, W6)≤0.5, (W2+W9)/min(W4, W5, W6)≤0.5, W7/min(W4, W5, W6)≤0.5, W8/min(W4, W5, W6)≤0.05, |W8-W7|/min(W4, W5, W6) ≤ 0.25, |W8-W7|/|W8+W7|≤0.4.

49. The display panel according to claim 48, wherein,
a line width spacing ratio K_{ws} of each of the gate lines satisfies K_{ws}=Wₘ/Sₘ, where Wₘ is a line width of the each of the gate lines, Sₘ is a spacing between adjacent ones of the gate lines, and a value of K_{ws} is in the range of 0 to 1;
a fluctuation slope Kₑₘ of a convex part of the planarization layer corresponding to each of the gate lines Kₑₘ = Hₑₘ/Lₑₘ, where Hₑₘ is a convex height of the convex part and Lₑₘ is a convex width of the convex part, and a value of Kₑₘ is in the range of 1 to 2;
the fluctuation slope Kₑₘ of the planarization layer and the line width spacing ratio K_{ws} of each of the gate lines satisfy Kₑₘ= aK_{ws}³ +bK_{ws}²+ cK_{ws} +d, where a ranges from -20 to 0, b ranges from 0 to 20, c ranges from -10 to 10, and d ranges from -10 to 10.

50. The display panel according to claim 49, wherein a formula obtained by polynomial fitting the fluctuation slope Kₑₘ of the planarization layer and the line width spacing ratio K_{ws} of each of the gate lines is Kₑₘ= -5.5036K_{ws}³ +4.8397K_{ws}²+ 0.7095K_{ws} +0.8259, and a determination coefficient R² = 0.9699.

51. The display panel according to any one of claims 6 to 10, further comprising a light emitting element arranged at a side of the first electrode away from the base substrate, wherein the light emitting element comprises a light emitting layer and an organic functional layer stacked with the light emitting layer, and the light emitting layer is formed by a printing process, and the organic functional layer is formed by a vapor deposition process.

52. The display panel according to claim 51, wherein,
the light emitting element comprises a red light emitting element, a green light emitting element and a blue light emitting element;
a ratio of a thickness of a red light emitting layer included in the red light emitting element to a peak wavelength of red light ranges from 0.15 to 0.4;
a ratio of a thickness of a green light emitting layer included in the green light emitting element to a peak wavelength of green light ranges from 0.15 to 0.3;
a ratio of a thickness of a blue light emitting layer included in the blue light emitting element to a peak wavelength of blue light ranges from 0.1 to 0.2.

53. The display panel according to claim 52, wherein,
a ratio of a sum of thicknesses of a plurality of red light emitting layers and corresponding organic functional layers to the peak wavelength of red light ranges from 0.2 to 0.4;
a ratio of a sum of thicknesses of a plurality of green light emitting layers and corresponding organic functional layers to the peak wavelength of green light ranges from 0.2 to 0.3;
a ratio of a sum of thicknesses of a plurality of blue light emitting layers and corresponding organic functional layers to a peak wavelength of blue light ranges from 0.15 to 0.25.

54. A display device, comprising the display panel according to any one of claims 1 to 53.
